(19) Europäisches Patentamt
European Patent Office
Office européen des brevets

(11) **EP 4 716 427 A1**

(12) **EUROPEAN PATENT APPLICATION**

(43) Date of publication:
**25.03.2026 Bulletin 2026/13**

(21) Application number: **25203272.7**

(22) Date of filing: **19.09.2025**

(51) International Patent Classification (IPC):
**H10H 29/30** *(2025.01)* **H10H 29/41** *(2025.01)*
**H10H 29/853** *(2025.01)* **H10H 29/855** *(2025.01)*
**H10H 29/80** *(2025.01)*

(52) Cooperative Patent Classification (CPC):
**H10H 29/352; H10H 29/41; H10H 29/853;**
H10H 29/8552; H10H 29/882

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **19.09.2024 CN 202411306437**

(71) Applicant: **Tianma Advanced Display Technology
Institute
(Xiamen) Co., Ltd.
361101 Xiamen (CN)**

(72) Inventors:
• **HE, Wei**
**Xiamen, Fujian, 361101 (CN)**
• **FENG, Yangui**
**Xiamen, Fujian, 361101 (CN)**
• **ZHANG, Ning**
**Xiamen, Fujian, 361101 (CN)**
• **YANG, Ming**
**Xiamen, Fujian, 361101 (CN)**

(74) Representative: **Germain Maureau
12, rue Boileau
69006 Lyon (FR)**

(54) **DISPLAY PANEL AND DISPLAY APPARATUS**

(57)     The present disclosure provides a display panel and a display apparatus. The display panel includes a light-blocking layer, and a thickness of the light-blocking layer in a first region included in the display panel is different from a thickness of the light-blocking layer in a second region included in the display panel.

A-A

**FIG. 2**

## Description

## TECHNICAL FIELD

The present disclosure generally relates to the field of display technology and, more particularly, relates to a display panel and a display apparatus.

## BACKGROUND

With the expansion of market demand and the continuous expansion of application fields in the display industry, display products are showing a trend of diversification. In the actual application of display products, the presence of ambient light may directly affect the contrast of display pictures. Thus, low contrast or uneven contrast may affect the viewing effect and reduce viewing experience of users.

## SUMMARY

To address the above technical issues, the present disclosure provides a display panel and a display apparatus, which are designed to enhance the anti-reflection effect, improve the image contrast, and increase the uniformity of overall contrast, thereby improving the display performance and enhancing the user's viewing experience.

One aspect of the present disclosure provides a display panel. The display panel includes a light-blocking layer, and a thickness of the light-blocking layer in a first region included in the display panel is different from a thickness of the light-blocking layer in a second region included in the display panel.

Another aspect of the present disclosure provides a display apparatus including a display panel. The display panel includes a light-blocking layer, and a thickness of the light-blocking layer in a first region included in the display panel is different from a thickness of the light-blocking layer in a second region included in the display panel.

Other embodiments in the summary are as disclosed in the claims as appended.

In the display panel and display apparatus according to embodiments of the present disclosure, the first region and the second region are provided. The structures in the first region and the second region may have differences, such as whether the light-emitting elements are configured, whether the pixel driving circuits are configured, the color difference of the light-emitting elements or the like. Based on possible structural differences in the first region and the second region, in the present disclosure, the thickness of the light-blocking layer in the first region may be configured to be different from the thickness of the light-blocking layer in the second region, which may be beneficial for reducing the reflectivity of the first region and the second region, balancing the difference in anti-reflection effect in the first region and the second region and improving the consistency of overall anti-reflection effect, and further beneficial for improving the consistency of overall contrast of the display product, the display effect, and the viewing experience of the user.

## BRIEF DESCRIPTION OF THE DRAWINGS

The accompanying drawings, which are incorporated into a part of the specification, illustrate embodiments of the present disclosure and together with the description to explain the principles of the present disclosure.

In order to clearly explain embodiments of the present disclosure or the technical solutions in the existing technology, the drawings required for describing embodiments or the existing technology are briefly introduced hereinafter. Obviously, the drawings in the following description are merely embodiments of the present disclosure. Other drawings may also be obtained by those skilled in the art without any creative work according to provided drawings.

The structures, proportions, sizes, etc. shown in the drawings of this specification are only used to match the contents disclosed in the specification for people familiar with this technology to understand and read, and are not used to limit the restrictive conditions that may be implemented in the present disclosure. Therefore, they have no technical substantive significance. Any structural modification, change in proportional relationship or adjustment of size should still fall within the scope of the technical content disclosed in the present disclosure without affecting the effects and purposes that may be achieved by the present disclosure.

FIG. 1 illustrates a planar schematic of a display panel according to various embodiments of the present disclosure.
FIG. 2 illustrates a cross-sectional view along an AA direction in FIG. 1.
FIG. 3 illustrates a partial top view of a display panel according to various embodiments of the present disclosure.
FIG. 4 illustrates another cross-sectional view along an AA direction in FIG. 1.
FIG. 5 illustrates another cross-sectional view along an AA direction in FIG. 1.
FIG. 6 illustrates a cross-sectional view along a BB direction in FIG. 3.
FIG. 7 illustrates another cross-sectional view along an AA direction in FIG. 1.
FIG. 8 illustrates a relative position relationship schematic of a light-emitting element in the first opening at lowest points of the first curved surface and the second curved surface in FIG. 7.
FIG. 9 illustrates another planar schematic of a display panel according to various embodiments of the present disclosure.

FIG. 10 illustrates a cross-sectional view along a CC direction in FIG. 9.

FIG. 11 illustrates another cross-sectional view along a CC direction in FIG. 9.

FIG. 12 illustrates a cross-sectional view along a DD direction in FIG. 9.

FIG. 13 illustrates a structural schematic of a light-emitting element according to various embodiments of the present disclosure.

FIG. 14 illustrates a formation process schematic of a display panel according to various embodiments of the present disclosure.

FIG. 15 illustrates another formation process schematic of a display panel according to various embodiments of the present disclosure.

FIG. 16 illustrates another formation process schematic of a display panel according to various embodiments of the present disclosure.

FIG. 17 illustrates another cross-sectional view along a CC direction in FIG. 9.

FIG. 18 illustrates a structural schematic of a light-emitting element according to various embodiments of the present disclosure.

FIG. 19 illustrates another cross-sectional view along a CC direction in FIG. 9.

FIG. 20 illustrates another cross-sectional view along a CC direction in FIG. 9.

FIG. 21 illustrates another partial top view of a display panel according to various embodiments of the present disclosure.

FIG. 22 illustrates a cross-sectional view along an EE direction in FIG. 21.

FIGS. 23-24 illustrate film layer schematics of the relationship between light-blocking layers in the first region, the second region, and the third region according to various embodiments of the present disclosure.

FIG. 25 illustrates a structural schematic of a display apparatus according to various embodiments of the present disclosure.

## DETAILED DESCRIPTION

In order to clearly understand above-mentioned objectives, features and advantages of the present disclosure, the solutions of the present disclosure are further described hereinafter. It should be noted that embodiments of the present disclosure and the features in embodiments may be combined with each other if there is no conflict.

Specific details are described in the following description to facilitate thorough understanding of the present disclosure, but the disclosure may also be implemented otherwise than as described herein. Obviously, embodiments in the description are only a part of embodiments of the present disclosure, but not all embodiments.

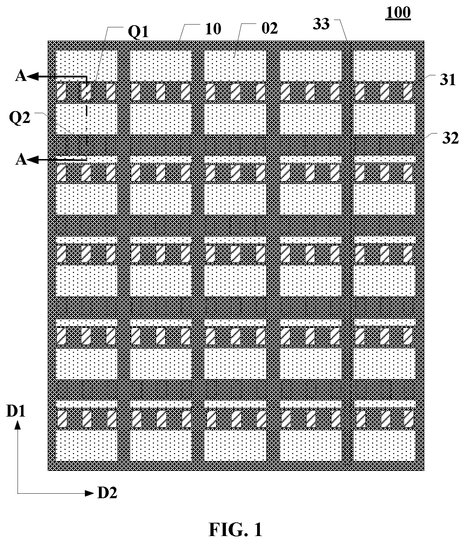

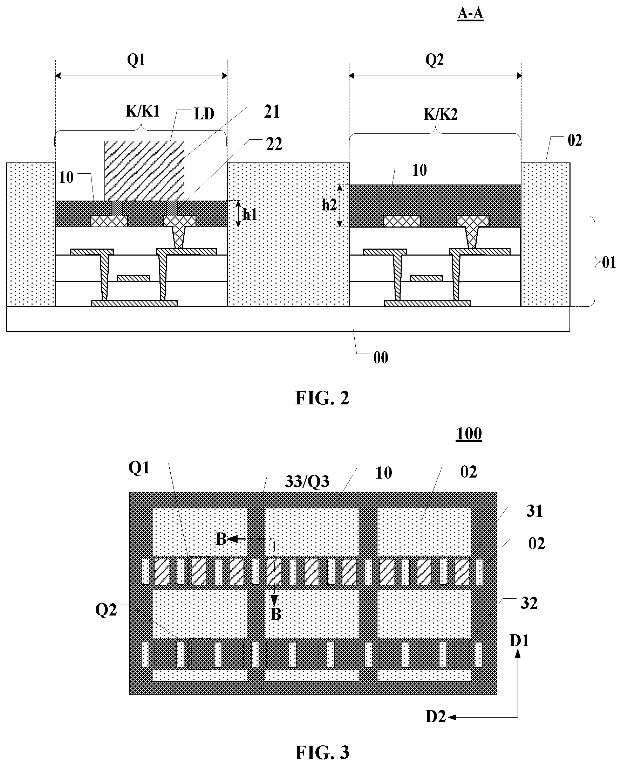

FIG. 1 illustrates a planar schematic of a display panel according to various embodiments of the present disclosure. FIG. 2 illustrates a cross-sectional view along an AA direction in FIG. 1. It should be noted that a display panel 100 of a rectangular structure is taken as an example for illustration in FIG. 1, which may not limit actual shape of the display panel. In some other embodiments of the present disclosure, the display panel may also be embodied in any other feasible shape such as a circle, a rounded rectangle, or the like.

In an embodiment, the display panel provided in one embodiment may be a display panel using inorganic light-emitting diode display technology, such as a Micro LED display panel, a Mini LED display panel, or the like. Such type of display panel may have the advantages of high brightness, low power consumption, easy splicing and the like, and be widely used in display products.

In an embodiment, the display panel, including a substrate 00, a driving layer 01 disposed on the side of the substrate 00, and a light-emitting element LD, is taken as an example for illustration in FIG. 2. The light-emitting element LD may be electrically connected to the driving layer 01, and the driving signal required for light emission may be obtained through the driving layer 01.

In an embodiment, the driving layer 01 may be disposed with a driving circuit, and the driving circuit may be a circuit in the existing technology, which may not be limited in the present disclosure. It should be noted that the film structure included in the driving layer 01 in FIG. 2 may be merely for illustration and may not indicate actual number and dimension of film layers. The light-emitting element LD may be, for example, a Micro LED or a Mini LED.

Referring to FIGS. 1-2, the present disclosure provides the display panel 100 including the first region Q1 and the second region Q2, where the display panel may further include a light-blocking layer 10, and the thickness h1 of the light-blocking layer 10 in the first region Q1 may be different from the thickness h2 of the light-blocking layer 10 in the second region Q2.

The first region Q1 and the second region Q2 mentioned in the present disclosure refer to two different regions in the display panel. For example, the display panel may be configured with different regions such as a pixel region 31, a redundant pixel region 32, and a wiring region 33. Taking the Micro LED display panel as an example, the light-emitting element LD may be transferred to one side of the driving layer 01 by a mass transfer manner to be electrically connected to the driving layer 01. At this point, the region where the light-emitting element LD is disposed may be regarded as the pixel region 31 of the display panel. When a damaged pixel appears in the display panel, for example, a certain light-emitting element LD in the pixel region 31 does not emit light, it needs to repair the region of the light-emitting element LD which does not emit light. At this point, the redundant pixel region 32 may be configured in the display panel, and a redundant light-emitting element may be introduced in the redundant pixel region 32 to replace the light-emitting element LD which does not emit light. In order to drive the light-emitting element LD to emit light, the driving layer 01 of the display panel may be configured with a pixel driving circuit corresponding to the light-emitting element LD. In order to provide a signal to the pixel driving circuit, the wiring region 33 may be configured in the display panel. The signal may be transmitted to the pixel driving circuit through the wires of the wiring region 33, thereby driving the light-emitting element LD to emit light. For the pixel region 31 and the redundant pixel region 32, the driving layer 01 may include a metal portion electrically connected to the light-emitting element LD. For the wiring region 33, a metal wire may be disposed. If above-mentioned metal portion and the metal wire in the display panel are not blocked by the light-blocking layer 10, the ambient light may cause reflection when irradiating on above-mentioned metal portion and the metal wire, which may greatly reduce the contrast of the display panel and affect the viewing effect of the user. Therefore, in the present disclosure, the light-blocking layer 10 may be configured in the region where the metal portion and the metal wire are disposed, and the light-blocking layer 10 may be used to cover the metal portion and the metal wire, thereby avoiding or reducing the reflection problem caused by the metal structure and improving the contrast of the display panel.

In one embodiment, the first region Q1 may be any one of the pixel region 31, the redundant pixel region 32, and the wiring region 33 mentioned above. The second region Q2 may also be any one of the pixel region 31, the redundant pixel region 32 and the wiring region 33 mentioned above. The structures in the first region Q1 and the second region Q2 may have differences, such as whether the light-emitting elements are configured, whether the pixel driving circuits are configured, the color difference of the light-emitting elements or the like. Based on possible structural differences in the first region Q1 and the second region Q2, in the present disclosure, the thickness of the light-blocking layer 10 in the first region Q1 may be configured to be different from the thickness of the light-blocking layer 10 in the second region Q2, which may be beneficial for reducing the reflectivity of the first region Q1 and the second region Q2, balancing the difference in anti-reflection effect in the first region Q1 and the second region Q2 and improving the consistency of overall anti-reflection effect, and further beneficial for improving the consistency of overall contrast of the display product, the display effect, and the viewing experience of the user.

Referring to FIGS. 1-2, in embodiments of the present disclosure, the display panel may be a transparent display panel, which is taken as an example to further describe the present disclosure. For the transparent display panel technology, a light-transmitting layer 02 may be disposed in the display region of the display panel, such that the light behind the display panel can penetrate the display panel and be perceived by the human eye in front of the display panel, thereby achieving the effect of transparent display. The pixel driving circuits and wires may be not disposed in the light-transmitting region corresponding to the light-transmitting layer 02 to achieve the light-transmitting demand of such region.

Referring to FIGS. 1-2, in an embodiment of the present disclosure, the display panel may further include a light-transmitting layer 02. The light-transmitting layer 02 may include openings K. The openings K may include the first opening K1 and the second opening K2. The light-blocking layer 10 may be disposed in the first opening K1 and the second opening K2. The thickness of the light-blocking layer 10 in the first opening K1 and the second opening K2 may be different.

In an embodiment, the first opening K1 may be in above-mentioned first region Q1, and the second opening K2 may be in above-mentioned second region Q2. It should be noted that the relative positional relationship between the light-transmitting layer 02, the first region Q1, the second region Q2 and the light-blocking layer 10 in FIG. 1 may be only exemplary, which may not be limited in the present disclosure. The arrangement of the first region Q1 and the second region Q2 may also be only exemplary.

In the process of forming the transparent display panel, after forming the driving circuits, the wires and light-emitting elements LD on one side of the substrate 00, the film layer in the regions of the display panel where the driving circuits, light-emitting elements LD and wires are not disposed may be removed (for example, only the substrate 00 may be retained), and the light-transmitting layer 02 may be formed in corresponding regions to improve the transparency of the transparent display panel. After the light-transmitting layer 02 is formed, original pixel region 31, the redundant pixel region 32 and the wiring region 33 may be confined in the openings formed by the light-transmitting layer 02. The light-transmitting layer 02 forms openings, which may be understood as a shape of the cross section perpendicular to the plane of the light-emitting surface of the display panel (such as the cross section shown in FIG. 2) may be that two sides of local light-blocking layer 10 may be clamped by the light-transmitting layer 02. Alternatively, the openings may be understood as, in the cross section, the light-blocking layer 10 may be disposed in the missing or hollowed-out region between local light-transmitting layers 02. Therefore, although the light-blocking layer 10 is in the opening of the light-transmitting layer 02 in the present disclosure, it does not indicate that the light-blocking layers 10 in different regions are separated or blocked by the light-transmitting layer 02, and also, does not indicate that overall region of the light-transmitting layer 02 is larger than overall region of the light-blocking layer 10.

In some embodiments, the dimension of the opening K may also be understood as the presented or visible dimension in above cross section. It should be noted that the openings shown in FIGS. 1-2 may be non-enclosed openings, and the light-transmitting layer 02 may be on two sides of the opening K along the first direction D1, which may not be limited in the present disclosure.

The relative position of the opening K and the light-transmitting layer 02 can also be embodied as other manners. Exemplarily, referring to FIG. 3, FIG. 3 illustrates a partial top view of the display panel according to various embodiments of the present disclosure. In one embodiment, the light-transmitting layer 02 may be on two sides of the first region Q1 along the first direction D1 and on two sides along the second direction D2. Such configuration may increase the region of the light-transmitting layer 02 in the display panel, which may be beneficial for improving overall transmittance of the display panel.

Referring to FIG. 2, when the light-blocking layer 10 is subsequently formed, the light-blocking layer 10 may be filled in the opening corresponding to the light-transmitting layer 02. In one embodiment, the first opening K1 corresponding to the light-transmitting layer 02 may be in the first region Q1, and the first region Q1 may be, for example, any one of the pixel region 31, the redundant pixel region 32, and the wiring region 33. The second opening K2 may be in the second region Q2, and the second region Q2 may be, for example, any one of the pixel region 31, the redundant pixel region 32, and the wiring region 33.

In one embodiment shown in FIG. 1, the first region Q1 may be the pixel region 31, and the second region Q2 may be the redundant pixel region 32, which is taken as an example for illustration. In addition, the redundant pixel region 32 not disposed with the light-emitting element LD is taken as an example for illustration in FIG. 1, which may not be limited in the present disclosure. When the light-emitting element LD in the pixel region 31 does not emit light, the light-emitting element LD may be disposed in corresponding redundant pixel region 32 to replace original light-emitting element LD that does not emit light. In the present disclosure, the light-blocking layer 10 may be disposed in the first opening K1 and the second opening K2, which may be beneficial for avoiding or reducing the metal reflection phenomenon in the first opening K1 and the second opening K2.

Furthermore, in one embodiment, the thickness of the light-blocking layer 10 in the first opening K1 may be different from the thickness of the light-blocking layer 10 in the second opening K2, which may be beneficial for balancing the difference in reflection effect due to the structural difference in the first opening K1 and the second opening K2 and improving the consistency of overall anti-reflection effect, and further being beneficial for improving the consistency of overall contrast of the display panel, the display effect and the viewing experience of the user.

Referring to FIG. 2, in an embodiment of the present disclosure, the top surface of at least a part of the light-blocking layer 10 may not exceed the top of the opening K where at least a part of the light-blocking layer 10 is located. For example, when the light-transmitting layer 02 includes the first opening K1 and the second opening K2 as shown in FIG. 2, the light-blocking layer 10 in the first opening K1 may not exceed the top of the first opening K1, and the light-blocking layer 10 in the second opening K2 may not exceed the top of the second opening K2. In an embodiment, the orthographic projection of the light-blocking layer 10 on the plane of the substrate 00 may be within the orthographic projection range of the corresponding opening K on the plane of the substrate 00, and the light-blocking layer 10 may not be overlapped with other regions of the light-transmitting layer 02 except the region where the opening K is located. In such way, the light-blocking layer 10 may not block the light-transmitting region of the light-transmitting layer 02, which may be beneficial for ensuring the light-transmitting region of the display panel and improving the transparency of the display panel.

Referring to FIG. 2, in an embodiment of the present disclosure, among the plurality of first regions Q1, the thickness h1 of the light-blocking layer 10 of at least a part of the first regions Q1 may be less than the thickness h2 of the light-blocking layer 10 of the second region Q2. At this point, in an embodiment, the first region Q1 may be disposed with the light-emitting element LD, and the second region Q2 may be the redundant pixel region 32 without the light-emitting element LD or the wiring region 33.

In one embodiment, the first region Q1 may be disposed with the light-emitting element LD. The first region Q1 may be, for example, the pixel region 31 in above-mentioned embodiments. Corresponding light-emitting element LD may be the light-emitting element of the pixel region 31 transferred to the side of the driving layer 01 by a mass transfer manner. In addition, the first region Q1 may also be the redundant pixel region 32 disposed with the light-emitting element LD. Corresponding light-emitting element LD may be the light-emitting element transferred to the redundant pixel region 32 to reduce defect after the light-emitting element LD which does not emit light appears in the pixel region 31. For the first region Q1 disposed with the light-emitting element LD, before being electrically connected to the light-emitting element LD, the driving layer 01 may expose a metal structure to be electrically connected to the light-emitting element LD. After the light-emitting element LD is transferred to the first region Q1, the electrode 22 of the light-emitting element LD may be electrically connected to above-mentioned metal structure. After the light-blocking layer 10 is introduced into the first region Q1, the light-blocking layer 10 may be used to block above-mentioned electrode 22 and the metal structure. Since the light-emitting chip 21 of the light-emitting element LD itself can partially block the electrode 22 and the metal structure, the thickness of the light-blocking layer 10 introduced in the first region Q1 may be configured to be relatively small, which may be less than the thickness of the light-blocking layer 10 in the second region Q2. The second region Q2 may be not disposed with the light-emitting element LD. When the second region Q2 is the redundant pixel region 32, the metal structure supposed to be used for electrical connection with the light-emitting element LD may be exposed in the second region Q2. When the second region Q2 is the wiring region 33, the second region Q2 may expose the metal wire. Therefore, the metal structure or metal wire in the second region Q2 may be completely blocked by the light-blocking layer 10, and the thickness of the light-blocking layer 10 in the second region Q2 may be configured to be relatively large, which may be greater than the thickness of the light-blocking layer 10 in the first region Q1. In such way, it is beneficial to balance the blocking effect of the first region Q1 disposed with the light-emitting element LD and the second region Q2 not disposed with the light-emitting element LD by the light-blocking layer 10, thereby balancing the difference in anti-reflection effect between the first region Q1 and the second region Q2, being beneficial for improving the consistency of overall anti-reflection effect of the display panel and further being beneficial for improving the consistency of overall contrast of the display panel and the display effect.

Referring to FIG. 2, in an embodiment of the present disclosure, the display panel may further include the light-transmitting layer 02. The light-transmitting layer 02 may include the openings K. The openings K may include the first opening K1 and the second opening K2. The first opening K1 may be in the first region Q1. The second opening K2 may be in the second region Q2. The projection areas of the first opening K1 and the second opening K2 may be the same.

In one embodiment, the first region Q1 may be disposed with the light-emitting element LD, for example, may be the pixel region 31 or the redundant pixel region 32 disposed with the light-emitting element LD.

In one embodiment, the projection areas of the first opening K1 and the second opening K2 may be same, and the second region Q2 may be not disposed with the light-emitting element LD. At this point, the second region Q2 may be regarded as the redundant pixel region 32 not disposed with the light-emitting element LD. In the formation process of the display panel, when the light-emitting element LD is not considered, the redundant pixel region 32 and the pixel region 31 may have same structures, for example, the dimensions and shapes of corresponding openings may be same, and the volumes of the openings may be same. It should be noted that "same" mentioned in one embodiment refers to same within the allowable error range.

In one embodiment, the redundant pixel region 32 and the pixel region 31 may be configured to have same structures, such that the redundant pixel region 32 may be used to reliably repair the light-emitting element LD of the pixel region 31 which does not emit light.

When the first region Q1 is the pixel region 31 or the redundant pixel region 32 disposed with the light-emitting element LD, and when the second region Q2 is the redundant pixel region 32 not disposed with the light-emitting element LD, without considering the thickness difference of the light-blocking layer 10 between the first region Q1 and the second region Q2, the difference between the first region Q1 and the second region Q2 may be only whether the light-emitting element LD is disposed, and the areas of corresponding openings of two regions may same. In embodiments of the present disclosure, the thickness of the light-blocking layer 10 in the first region Q1 may be configured to be less than the thickness of the light-blocking layer 10 in the second region Q2. At this point, in an embodiment, the difference between the thickness h2 of the light-blocking layer 10 in the second region Q2 and the thickness h1 of the light-blocking layer 10 in the first region Q1 is calculated as:

$$\Delta h = (H*C*\omega)/C - (H*C-V)*\omega)/(C-S),$$

where V denotes the volume of the light-emitting chip 21 in the light-emitting element LD, S denotes the volume of the electrode 22 in the light-emitting element LD, H denotes the thickness of the light-transmitting layer 02, C denotes the volume of the opening, and $\omega$ denotes the solid content of the light-blocking layer 10.

In one embodiment, the thickness difference between the light-blocking layer 10 in the first region Q1 and the light-blocking layer 10 in the second region Q2 may refer to the height difference between the top surface of the light-blocking layer 10 in the first region Q1 and the top surface of the light-blocking layer 10 in the second region Q2. The top surface of the light-blocking layer 10 mentioned in one embodiment refers to the plane where the highest point of the light-blocking layer 10 in corresponding opening is located. In the process of forming the display panel, after the light-transmitting layer 02 is formed, the pixel region 31, the redundant pixel region 32, and the wiring region 33 may be in the opening. When forming the light-blocking layer 10, the light-blocking layer 10 may first cover entire surface of the transparent layer on the side away from the substrate 00. At this point, the light-blocking layer 10 may also be filled into each opening, and finally the light-blocking layer in the transparent region may be removed by a manner including photolithography or the like. In the process of removing the light-blocking layer 10 in the transparent region (i.e., the light-transmitting region), the light-blocking layer 10 in the opening may also be affected by the photolithography process to make the height of the light-blocking layer 10 to decrease. When the first region Q1 is the pixel region 31 or the redundant pixel region 32 disposed with the light-emitting element LD, and when the second region Q2 is the redundant pixel region 32 not disposed with the light-emitting element LD, along the first direction D1, the first opening K1 corresponding to the first region Q1 and the second opening K2 corresponding to the second region Q2 may have same width. Along the first direction D1, the width of the light-blocking layer 10 accommodated in the first opening K1 may be equal to the width of the light-blocking layer 10 that may be accommodated in the second opening K2. Since the first opening K1 is disposed with the light-emitting element LD and the second opening K2 is not disposed with the light-emitting element, after removing the unnecessary light-blocking layer 10 by a process including photolithography or the like, the thickness of the light-blocking layer 10 retained in the first opening K1 may be less than the thickness of the light-blocking layer 10 retained in the second opening K2. Furthermore, only one process of removing the light-blocking layer 10 is needed to achieve that the thickness of the light-blocking layer 10 in the first opening K1 is less than that in the second opening K2, which may be beneficial for simplifying the formation process of the display panel while balancing the anti-reflection effect of the first region Q1 and the second region Q2. It should be noted that in one embodiment, the first opening K1 corresponding to the first region Q1 and the second opening K2 corresponding to the second region Q2 have same width along the first direction D1, which may indicate that the width of the first opening K1 and the second opening K2 may be consistent to each other along the cross section perpendicular to the plane of the display panel and in parallel with the first direction D1 (for example, the cross section corresponding to FIG. 2). That is, the comparison may be the dimensions of the first opening K1 and the second opening K2 shown in above-mentioned cross section. It should also be noted that in embodiments of the present disclosure, the comparison of the width or thickness of the light-blocking layer 10 may be also the comparison of the dimension of the light-blocking layer 10 in above-mentioned cross section.

Referring to FIGS. 1-2, when the first region Q1 is the pixel region 31 or the redundant pixel region 32 disposed with the light-emitting element LD, and when the second region Q2 is the redundant pixel region 32 not disposed with the light-emitting element LD, a feasible implementation of the present disclosure may be that the thickness of the light-blocking layer 10 in the first region Q1 may be less than the thickness of the light-blocking layer 10 in the second region Q2. At this point, in an embodiment, the difference between the thickness h2 of the light-blocking layer 10 in the second region Q2 and the thickness h1 of the light-blocking layer 10 in the first region Q1 may be $\Delta h = V*\omega/C$, where V denotes the volume of the light-emitting element LD chip, $\omega$ denotes the solid content of the light-blocking layer 10, and C denotes the volume of the opening.

When the volume S of the electrode 22 of the light-emitting chip 21 is relatively small and significantly smaller than the opening volume C, $\Delta h = (H*C*\omega)/C-(H*C-V)*\omega)/(C-S)$ may be simplified to $\Delta h = (H*C*\omega)/C-(H*C-V)*\omega)/C$, and further simplified to $\Delta h = V*\omega/C$. That is, the difference between the thickness of the light-blocking layer 10 in the first region Q1 and the thickness of the light-blocking layer 10 in the second region Q2 may be related to the volume V of the light-emitting chip 21 in the light-emitting element LD, the solid content $\omega$ of the light-blocking layer 10, and the volume C of the opening. The first region Q1 may be disposed with the light-emitting element LD, which can partially block the metal structure of the region. When the light-blocking layer 10 having the thickness less than the thickness of the light-blocking layer 10 of the second region Q2 by $V*\omega/C$ is used for further blocking, it is beneficial to make the light-blocking effect of the first region Q1 close to the light-blocking effect of the second region Q2, and the anti-reflection effect may be approximately same, thereby being beneficial for improving overall display effect of the display panel.

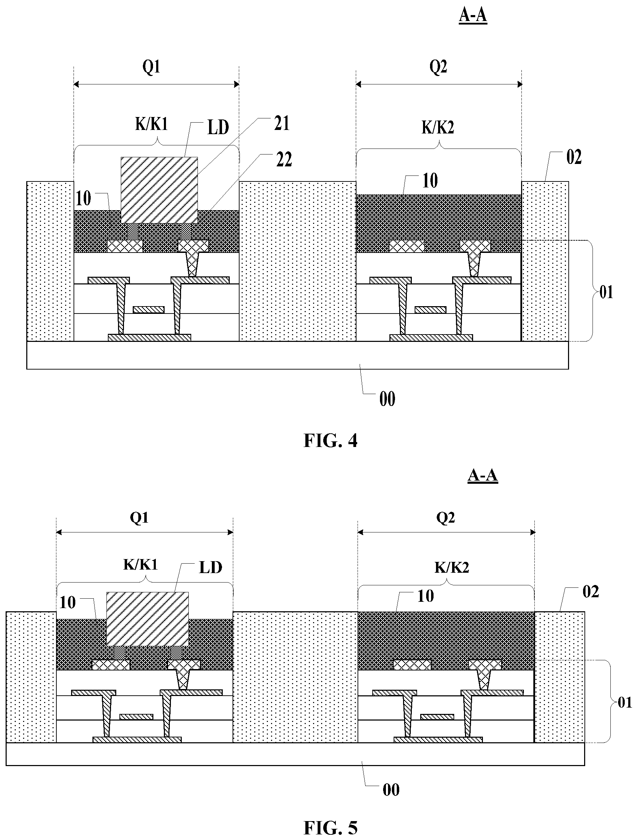

FIG. 4 illustrates another cross-sectional view along an AA direction in FIG. 1. Referring to FIG. 4, in an embodiment of the present disclosure, in the first region Q1, the light-blocking layer 10 may expose at least a part of the sidewalls of the light-emitting element LD.

For example, in one embodiment, it describes the solution that a part of the sidewalls of at least one light-emitting element LD in the display panel is blocked by the light-blocking layer 10 and a part of the sidewalls is not blocked by the light-blocking layer 10. That is, the light-blocking layer 10 may expose at least a part of the sidewalls of the light-emitting element LD. In such way, the light emitted by the light-emitting element LD may not only be emitted from the front of the light-emitting element LD, but also from at least a part of the sidewalls exposed by the light-blocking layer 10, which may be beneficial for increasing overall light output of the light-emitting element LD, thereby being beneficial for improving the light-emitting brightness of the light-emitting element LD. It should be noted that the light-emitting element LD may include the light-emitting chip 21 and the electrode 22 located on one side of the light-emitting chip 21. The sidewalls of the light-emitting element LD mentioned in one embodiment refer to the sidewalls of the light-emitting chip 21 in the light-emitting element LD that can emit light.

Referring to FIGS. 1-2, in an embodiment of the present disclosure, in the plurality of light-emitting elements LD, the sidewalls of a part of the light-emitting elements LD may not be covered with the light-blocking layer 10. It should be noted that the sidewalls of the light-emitting element LD in one embodiment refer to the sidewalls of the light-emitting chip 21 in the light-emitting element LD.

For example, in one embodiment, it describes the solution that the sidewalls of at least one light-emitting element LD in the display panel may be not covered with the light-blocking layer 10. That is, the sidewalls of the light-emitting element LD may be exposed outside the light-blocking layer 10 as a whole. When the light-emitting element LD emits light, the light may be emitted from the sidewalls of the light-emitting element LD, thereby increasing the amount of light at a large viewing angle of the light-emitting element LD and further being beneficial for improving overall brightness of the light-emitting element LD. For the light-emitting elements LD with low light-emitting efficiency in the display panel, the sidewalls of the light-emitting elements LD may be exposed outside the light-blocking layer 10 using above manner, thereby improving the light-emitting brightness of the light-emitting elements LD with low light-emitting efficiency in the display panel and balancing the light-emitting brightness difference of the light-emitting elements LD with different light-emitting efficiencies in the display panel. It should be noted that which sidewalls of the light-emitting elements LD in the display panel are exposed outside the light-blocking layer 10 may be configured according to actual needs, which may not be limited in the present disclosure.

Referring to FIG. 4, in an embodiment of the present disclosure, in the plurality of light-emitting elements LD, the sidewalls of a part of the light-emitting elements LD may be covered with the light-blocking layer 10.

In one embodiment, when the sidewalls of the light-emitting elements LD are blocked by the light-blocking layer 10, the light output of the light-emitting elements LD at a large viewing angle may be reduced. By disposing the light-blocking layer 10 on at least a part of the sidewalls of the light-emitting elements LD, the light output of the light-emitting elements LD at a large viewing angle may be adjusted, thereby realizing adjustment of the brightness of corresponding light-emitting elements LD at a large viewing angle and overall brightness of the light-emitting elements LD. In practical applications, which sidewalls of the light-emitting elements LD are blocked by the light-blocking layer 10 may be selected according to actual needs, and the thickness of the light-blocking layer 10 on the sidewalls of the light-emitting elements LD may be configured, which may not be limited in the present disclosure.

In one embodiment, as shown in FIG. 4, a part of the sidewalls of at least one light-emitting element LD is blocked by the light-blocking layer 10, and a part of the sidewalls is not blocked by the light-blocking layer 10, which is taken as an example for illustration. In some other embodiments of the present disclosure, in at least one light-emitting element LD, the blocking amount of the light-blocking layer 10 on corresponding sidewalls (i.e., the thickness of the light-blocking layer 10) may be adjusted according to actual needs. For example, referring to FIG. 5, FIG. 5 illustrates another cross-sectional view along an AA direction in FIG. 1. Compared with FIG. 4, in one embodiment, the blocking amount of the light-blocking layer 10 on the sidewalls of the light-emitting chip 21 in the light-emitting element LD may be increased in FIG. 5, which may further reduce the lateral light output of the light-emitting element LD.

It should be noted that the relative positional relationships between one light-emitting element LD and the light-blocking layer 10 in the display panel may be shown in embodiments of FIGS. 2, 4 and 5. The first scenario is that the light-blocking layer 10 may not cover the sidewalls of the light-emitting chip 21 in the light-emitting element LD. The second scenario is that the light-blocking layer 10 may cover the sidewalls of the light-emitting chip 21 in the light-emitting element LD with a relatively small region (corresponding to a relatively small thickness of the light-blocking layer). The third scenario is that the light-blocking layer 10 may cover the sidewalls of the light-emitting chip 21 in the light-emitting element LD with a relatively large region (corresponding to a relatively large thickness of the light-blocking layer). When the plurality of light-emitting elements LD is disposed in the display panel, the positional relationships between different light-emitting elements LD and the light-blocking layer 10 may be embodied in any one of above three scenarios, or a combination of any two scenarios, or all three scenarios, which may not be limited in the present disclosure.

Referring to FIGS. 1, 2 and 5, when the first region Q1 is the pixel region 31 or the redundant pixel region 32 disposed with the light-emitting element LD, and when the second region Q2 is the redundant pixel region 32 not disposed with the light-emitting element LD, in an embodiment of the present disclosure, the plane where the top surface of the light-blocking layer 10 in the redundant pixel region 32 is located may be lower than the plane where the top surface of the light-emitting element LD in the first region Q1 is located.

In one embodiment, the first region Q1 may be disposed with the light-emitting element LD. The second region Q2 may be not disposed with the light-emitting element LD and the second region Q2 may be redundant pixel region 32. At this point, the thickness of the light-blocking layer 10 in the second region Q2 may be greater than the thickness of the light-blocking layer 10 in the first region Q1, and the top surface of the light-blocking layer 10 in the second region Q2 may be lower than the top surface of the light-emitting element LD in the first region Q1, thereby being beneficial for preventing the light-blocking layer 10 in the second region Q2 from blocking the light emitted by the light-emitting element LD and further ensuring the light brightness of the light-emitting element LD. In addition, when the top surface of the light-blocking layer 10 in the second region Q2 is configured to be lower than the top surface of the light-emitting element LD in the first region Q1, the metal structure may be blocked by the light-blocking layer 10 and the light-emitting chip 21 of the light-emitting element LD in the first region Q1 simultaneously. In the second region Q2, the metal structure may be blocked by the light-blocking layer 10 that the top surface is not higher than the top surface of the light-emitting element LD in the first region Q1, which may be beneficial for making the light-blocking effect of the light-blocking layer 10 in the redundant pixel region 32 closer to the light-blocking effect of the first region Q1 where the light-emitting element LD is disposed, thereby being beneficial for improving the consistency of the light-blocking effect of each region of the display panel and overall display effect of the display panel.

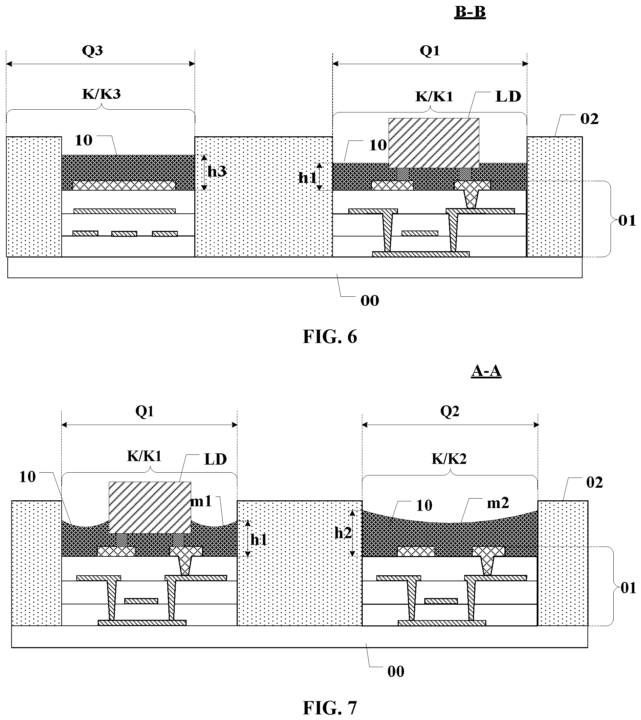

FIG. 6 illustrates a cross-sectional view along a BB direction in FIG. 3. Referring to FIGS. 2, 4, 5 and 6, in an embodiment of the present disclosure, the display panel provided by the present disclosure may further include the third region Q3. The thickness h1 of the light-blocking layer 10 in the first region Q1 may be less than the thickness h2 of the light-blocking layer 10 in the second region Q2, and less than the thickness h3 of the light-blocking layer 10 in the third region Q3. The thickness h3 of the light-blocking layer 10 in the third region Q3 may be less than or equal to the thickness h2 of the light-blocking layer 10 in the second region Q2. The light-transmitting layer 02 may include the third opening K. The third opening K3 may be in the third region Q3. It should be noted that the thickness of the light-blocking layer 10 mentioned in one embodiment refers to the thickness of the light-blocking layer 10 in the cross section perpendicular to the plane of the light-emitting surface of the display panel (such as the cross sections corresponding to FIGS. 2, 4, 5 and 6). The comparison of the thicknesses of the light-blocking layer 10 in different regions may actually be the comparison of the thicknesses of the light-blocking layer 10 in different regions in above-mentioned cross sections.

In one embodiment, when the display panel includes the third region Q3, in an embodiment, the third region Q3 may have different shapes and structures from the first region Q1 and the second region Q2. The orthographic projections of the first region Q1 and the second region Q2 on the light-emitting surface of the display panel may be, for example, a square structure. The orthographic projection of the third region Q3 on the light-emitting surface of the display panel may be a long strip structure. At this point, the thicknesses of the light-blocking layer 10 in the third region Q3 and other regions may be configured differently. For example, the thickness of the light-blocking layer 10 of the third region Q3 may be configured to be less than or equal to the thickness of the light-blocking layer 10 of the second region Q2. In such way, the light-blocking effect of the third region Q3 may be more consistent with the light-blocking effect of the first region Q1, which may be beneficial for balancing overall light-blocking effect of the first region Q1, the second region Q2 and the third region Q3 and improving the contrast consistency of different regions, and further beneficial for improving overall display effect of the display panel. In one embodiment, the first region Q1 may be disposed with the light-emitting element LD, and may be, for example, the pixel region 31 or the redundant pixel region 32 disposed with the light-emitting element LD. The second region Q2 may be the redundant pixel region 32 not disposed with the light-emitting element LD. The third region Q3 may be the wiring region 33. The wiring region 33 may be disposed with wires for providing signals to the pixel circuits in the pixel region 31 and the redundant pixel region 32, such as a signal line for providing a scan signal, a data line for providing a data signal, a reset line for providing a reset signal, a power line for providing a power signal and the like.

In one embodiment, the metal structure in the first region Q1 may be jointly blocked by the light-emitting element LD and the light-blocking layer 10. The metal structure in the second region Q2 may be blocked by the light-blocking layer 10. Therefore, the thickness of the light-blocking layer 10 in the first region Q1 may be configured to be less than the thickness of the light-blocking layer 10 in the second region Q2, thereby achieving balance between the light-blocking effect in the first region Q1 and the second region Q2. The third region Q3 may be, for example, a long strip structure disposed with wires. Neither the third region Q3 nor the second region Q2 may be disposed with the light-emitting element LD. When the thickness of the light-blocking layer 10 of the third region Q3 is configured to be less than or equal to the thickness of the light-blocking layer 10 of the second region Q2, it is beneficial for improving the consistency of the light-blocking effect in the third region Q3 and the second region Q2 and further improving the consistency of overall light-blocking effect of the third region Q3, the second region Q2 and the first region Q1, thereby improving the contrast consistency of different regions of the display panel and overall display effect.

In above-mentioned embodiments, it describes the solution that the top surface morphology of the light-blocking layer 10 in the opening K is a plane. In actual products, the top surface morphology of the light-blocking layer 10 may also be embodied as other forms. For example, referring to FIG. 7, FIG. 7 illustrates another cross-sectional view along an AA direction in FIG. 1. The difference from above-mentioned embodiment may be that the top surface morphology of the light-blocking layer 10 in the opening may be different. When the first region Q1 is the pixel region 31 or the redundant pixel region 32 disposed with the light-emitting element LD, and when the second region Q2 is the redundant pixel region 32 not disposed with the light-emitting element LD, the first opening K1 may be in the first region Q1, and the second opening K2 may be in the second region Q2. In an embodiment, the top surface morphology of the light-blocking layer 10 in the first opening K1 may be different from the top surface morphology of the light-blocking layer 10 in the second opening K2. It should be noted that the top surface morphology of the light-blocking layer 10 mentioned in one embodiment refers to the top surface morphology of the light-blocking layer 10 in the cross section perpendicular to the plane of the light-emitting surface of the display panel (for example, the cross section corresponding to FIG. 7). The comparison of the top surface morphologies of the light-blocking layer 10 in different regions may actually be the comparison of the top surface morphologies of the light-blocking layer 10 in different regions in above cross sections.

In one embodiment, when the light-emitting element LD is disposed in the first region Q1, the light-emitting element LD may be in the center region or near the center region corresponding to the first opening K1. When the light-blocking layer 10 is formed in the first opening K1, the light-blocking layer 10 may at least fill between the side of the light-emitting element LD and the sidewalls of the first opening K1. The light-emitting element LD may be not disposed in the second region Q2. When the light-blocking layer 10 is formed in the second opening K2, the light-blocking layer 10 may fill the space defined by the sidewalls corresponding to the second opening K2. The first opening K1 and the second opening K2 may or may not be disposed with the light-emitting element LD. Therefore, when the light-blocking layer 10 is formed into the first opening K1 and the second opening K2 respectively, the top surfaces of the light-blocking layer 10 in the first opening K1 and the second opening K2 may have different morphologies. For example, the cross-sectional structures of the light-blocking layer 10 in the first opening K1 and the second opening K2 may be different. As shown in FIG. 7, above-mentioned cross section may be, for example, a cross section formed at the position of the AA cross-sectional line shown in FIG. 1 along the direction perpendicular to the plane where the display panel is located. In such cross section, the morphology of the light-blocking layer 10 in the first opening K1 may be different from the morphology of the light-blocking layer 10 in the second opening K2.

In an embodiment, a part of the top surface of the light-blocking layer 10 may include a curved surface.

In one embodiment, the cross-sectional structure of the light-blocking layer 10 in the first opening K1 may be two curved surfaces and the cross-sectional structure of the light-blocking layer 10 in the second opening K2 may be one curved surface, which is taken as an example for illustration. When the top surface of the light-blocking layer 10 in the first opening K1 and the second opening K2 are configured as curved surfaces, the light-blocking layer 10 in the first opening K1 and the light-blocking layer 10 in the second opening K2 may have more consistent reflection effect on light rays, which may be beneficial for improving the contrast consistency of different regions in the display panel and overall display effect of the display panel. Furthermore, when the top surface of the light-blocking layer 10 in the first opening K1 and the second opening K2 are curved surface structures, the light-blocking layer 10 in the first opening K1 and the second opening K2 may be manufactured and formed in a same process. There is no need to introduce different formation processes for the light-blocking layer 10 in the first opening K1 and the second opening K2, thereby being beneficial for simplifying the formation process of the display panel and improving the formation efficiency.

Referring to FIG. 7, in an embodiment of the present disclosure, the light-emitting element LD may be disposed in the first opening K1. In the first opening K1, a part of the top surface of the light-blocking layer 10 may form the first curved surface m1. In the second opening K2, the top surface of the light-blocking layer 10 may form the second curved surface m2. The curvature of the first curved surface m1 may be different from the curvature of the second curved surface m2.

Due to the influence of the slope of the light-blocking layer 10 in the formation process, when the light-blocking layer 10 is formed in the first opening K1, the light-blocking layer 10 may extend on the side of the light-emitting element LD and the sidewall of the first opening K1 and form the first curved surface m1 with low center and high sides. In the cross-sectional view shown in FIG. 7, the top surface of the light-blocking layer 10 in the first opening K1 may be embodied as two first curved surfaces m1, and two first curved surfaces m1 may be respectively located on two sides of the light-emitting element LD. Since the light-emitting element LD is not disposed in the second opening K2, the light-blocking layer 10 may extend (slope influence) on the sidewalls of the second opening K2 and form the second curved surface m2 with a low center and high sides. The first opening K1 may be in the first region Q1. The first region Q1 may be the pixel region 31 or the redundant pixel region 32 disposed with the light-emitting element LD. The second opening K2 may be in the second region Q2. The second region Q2 may be the redundant pixel region 32 not disposed with the light-emitting element LD. At this point, the shapes and sizes of the first opening K1 and the second opening K2 may be consistent or nearly consistent to each other. Since the light-emitting element LD is disposed in the first opening K1 and the light-emitting element LD is not disposed in the second opening K2, the curvature of the first curved surface m1 formed in the first opening K1 between the light-emitting element LD and the sidewalls of the first opening K1 may be different from the curvature of the second curved surface m2 formed between the sidewalls in the second opening K2. In such way, the structural designs of the first opening K1 disposed with the light-emitting element LD and the second opening K2 not disposed with the light-emitting element LD may be configured to be more matched with each other, and the light-blocking requirements at the positions of the first opening K1 and the second opening K2 may be satisfied. Moreover, the curved surface in the first opening K1 and the second curved surface m2 in the second opening K2 may be formed in a same formation process without introducing additional formation process, which may be beneficial for simplifying overall formation process of the display panel and improving production efficiency.

Referring to FIGS. 1 and 7, in an embodiment of the present disclosure, the curvature of the first curved surface m1 corresponding to the light-blocking layer 10 in the first opening K1 may be less than the curvature of the second curved surface m2 corresponding to the light-blocking layer 10 in the second opening K2. When the first opening K1 is in the first region Q1 and the second opening K2 is in the second region Q2, when the first region Q1 is the pixel region 31 or the redundant pixel region 32 disposed with the light-emitting element LD, and when the second region Q2 is the redundant pixel region 32 not disposed with the light-emitting element LD, the light-blocking layer 10 in the first opening K1 may extend (slope influence) on the side of the light-emitting element LD and the sidewalls of the first opening K1 to form the first curved surface m1 with high sides and low center. The first curved surface m1 may be formed between the light-emitting element LD and the sidewalls of the first opening K1. The dimension between the side of the light-emitting element LD and the sidewall of the first opening K1 may be than the width of the first opening K1, such that the curvature of the first curved surface m1 may be relatively small. In the second opening K2, the light-blocking layer 10 may extend (slope influence) on the sidewalls of the second opening K2 to form the second curved surface m2 with high sides and low center. The width of the second opening K2 may be greater than the distance between the side of the light-emitting element LD in the first opening K1 and the sidewall of the first opening K1, such that the curvature of the second curved surface m2 may be greater than the curvature of the first curved surface m1. Therefore, the configuration manner that the curvature of the first curved surface m1 in the first opening K1 is less than the curvature of the second curved surface m2 in the second opening K2 may desirably match actual structural features in the first opening K1 and the second opening K2 and satisfy the light-blocking requirements of the light-blocking layer 10 for the metal structures in the first opening K1 and the second opening K2. Moreover, the top surfaces of the first light-blocking layer 10 and the second light-blocking layer 10 may be both curved surfaces, which may be also beneficial for balancing the light-blocking effect of the light-blocking layer 10 in the first opening K1 and the second opening K2 and improving the contrast consistency of different regions.

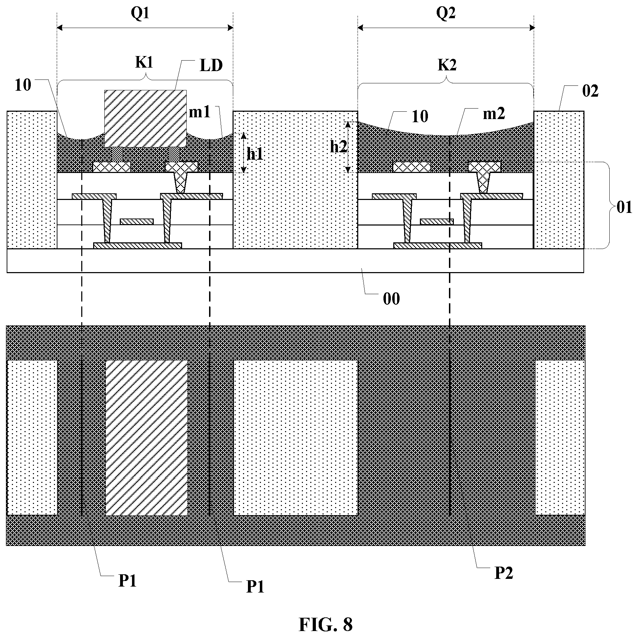

FIG. 8 illustrates a relative position relationship schematic of the light-emitting element LD in the first opening K1 at lowest points of the first curved surface and the second curved surface in FIG. 7. It should be noted that, in order to more clearly illustrate the structures at the lowest points of the first curved surface m1 and the second curved surface m2, in addition to showing the light-blocking layer 10 in the first opening K1 and the second opening K2 in FIG. 8, the top view structures at the lowest points in the first opening K1 and the second opening K2 may be also illustrated. In FIG. 8, the connection line of the lowest points of the first curved surface m1 may be two independent straight lines, and the connection line of the lowest point of the second curved surface m2 may be also one straight line for illustration, which may not be limited in the present disclosure. Referring to FIG. 8, in an embodiment of the present disclosure, the orthographic projection of the lowest point P1 of the first curved surface m1 on the light-emitting surface of the display panel may at least partially surround the light-emitting element LD. The orthographic projection of the lowest point P2 of the second curved surface m2 on the light-emitting surface of the display panel may be a line.

In one embodiment, the lowest point of the first curved surface m1 may be regarded as a combination of the lowest points of multiple U-shaped arcs obtained by intercepting the display panel where the planes passing through the center line of the first opening K1 and perpendicular to the light-emitting surface of the display panel may be considered as cross sections (the quantity of the cross sections is infinite).

In one embodiment, it describes that the line connecting the multiple lowest points of a single first curved surface m1 is a straight line as an example for illustration, which may not be limited in the present disclosure. Two first curved surfaces m1 may be formed in the first opening K1. The lowest points of the two first curved surfaces m1 may respectively form two straight lines on two sides of the light-emitting element LD, which may be equivalent to that the lowest points of two first curved surfaces m1 may be arranged in a manner of partially surrounding the light-emitting element LD in the first opening K1 and may not focus on the region where the light-emitting element LD is located. Such arrangement may be more beneficial for the emission of light from the light-emitting element LD and prevent crosstalk between different light-emitting elements LD. In the second opening K2, the lowest point of the second curved surface m2 may be regarded as a combination of the lowest points of multiple U-shaped arcs obtained by intercepting the display panel where the planes passing through the center line of the second opening K2 and perpendicular to the light-emitting surface of the display panel may be considered as cross sections (the quantity of the cross sections is infinite).

In one embodiment, the lowest points of the multiple U-shaped arcs corresponding to the second curved surface m2 may converge into a straight line for illustration. The top surface of the second curved surface m2 may form a U-shaped concave structure with low center and high sides as a whole. The lowest point of the second curved surface m2 in the second opening K2 may be in the center region or near the center region of the second opening K2, while the lowest points of two first curved surfaces m1 in the first opening K1 may be on two sides of the center region of the first opening K1.

Therefore, in one embodiment, the first curved surface m1 formed in the first opening K1 and the lowest point of the first curved surface m1 may be both between the side of the light-emitting element LD and the sidewall of the first opening K1, and the second curved surface m2 formed in the second opening K2 and the lowest point of the second curved surface m2 may be in the center region or near the center region of the second opening K2. It is equivalent to forming concave structures at the regions on two sides of the light-emitting element LD in the first region Q1 and also at the second region Q2 not disposed with the light-emitting element LD. The concave structures may be used to absorb ambient light in the region around the light-emitting element LD and other regions, which may be beneficial for improving the consistency of the light-blocking effect of the first region Q1 and the second region Q2, thereby being beneficial for improving the contrast consistency of different regions in the display panel and overall display effect. It should be noted that in one embodiment, the light-transmitting layer 02 located on two sides of the first region Q1 and the second region Q2 is taken as an example for illustration in FIG. 8. The first opening K1 and the second opening K2 may be openings with two sidewalls arranged opposite to each other and may be not closed openings.

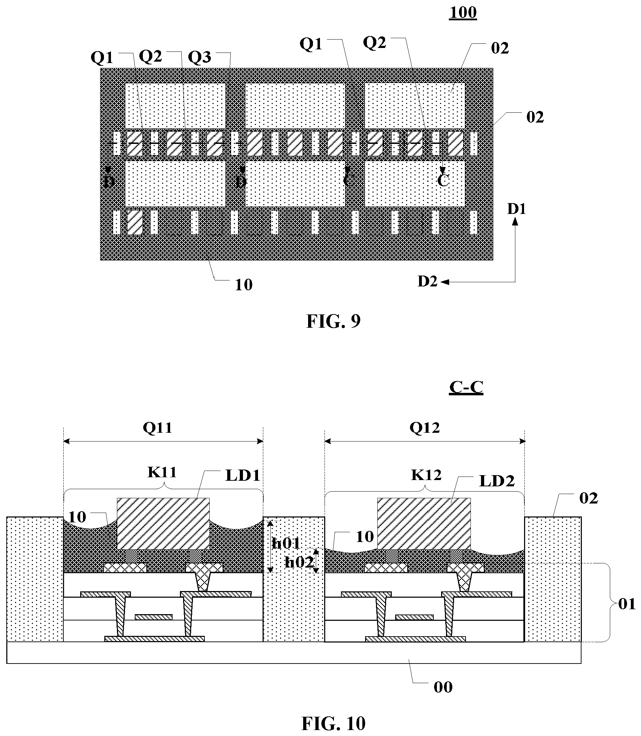

It should also be noted that, in above-mentioned embodiments, the first region Q1 may be the pixel region 31 or the redundant pixel region 32 disposed with the light-emitting element LD, the second region Q2 may be the redundant pixel region 32 not disposed with the light-emitting element LD, and the thickness of the light-blocking layer 10 in the first region Q1 may be less than the thickness of the light-blocking layer 10 in the second region Q2, which may be taken as an example for illustration and may not be limited in the present disclosure. Referring to FIGS. 9-10, FIG. 9 illustrates another planar schematic of the display panel according to various embodiments of the present disclosure. FIG. 10 illustrates a cross-sectional view along a CC direction in FIG. 9. The display panel may include a plurality of first regions Q11 and a plurality of second regions Q12.

In an embodiment, both the first region Q11 and the second region Q12 may be disposed with the light-emitting elements LD. At this point, the first region Q11 may be the pixel region 31 or the redundant pixel region 32 disposed with the light-emitting element LD, and the second region Q may also be embodied as the pixel region 31 or the redundant pixel region 32 disposed with the light-emitting element LD. In one embodiment, both the first region Q11 and the second region Q12 may be disposed with the light-emitting elements LD as an example for illustration. The first region Q11 may include the first opening K11, and the second region Q12 may include the second opening K12. In one embodiment, the thickness of the light-blocking layer 10 in the first region Q11 and the second region Q12 disposed with the light-emitting elements LD may be designed differently, which may be beneficial for balancing the difference in the light-emitting brightness of different light-emitting elements LD.

Referring to FIGS. 9-10, in an embodiment of the present disclosure, in the plurality of first regions Q11, the thickness of the light-blocking layer 10 of at least a part of the first regions Q11 may be greater than the thickness of the light-blocking layer 10 of the second region Q12.

In an embodiment, the light-emitting colors of the light-emitting elements LD disposed in the first region Q11 and the second region Q12 may be different. For example, the light-emitting efficiency of the light-emitting elements LD disposed in the first region Q11 may be higher than the light-emitting efficiency of the light-emitting elements LD disposed in the second region Q12. At this point, when the thickness of the light-blocking layer 10 of the first region Q11 is configured to be greater than the thickness of the light-blocking layer 10 of the second region Q12, exemplarily, the light-blocking layer 10 of the first region Q11 may be configured to cover at least a part of the sidewalls of the light-emitting elements LD in the first region Q11, and the light-blocking layer 10 of the second region Q12 may be configured to not cover the sidewalls of the light-emitting elements LD in the second region Q12. In such way, it is beneficial for reducing the lateral light output of the light-emitting elements LD with higher light-emitting efficiency in the first region Q11 and reducing overall light output of corresponding light-emitting elements LD, thereby being beneficial for balancing the difference in light-emitting brightness over a wide viewing angle between the light-emitting element LD with higher light-emitting efficiency in the first region Q11 and the light-emitting element LD with lower light-emitting efficiency in the second region Q12 and further being beneficial for improving the uniformity of light-emitting brightness between the first region Q11 and the second region Q12.

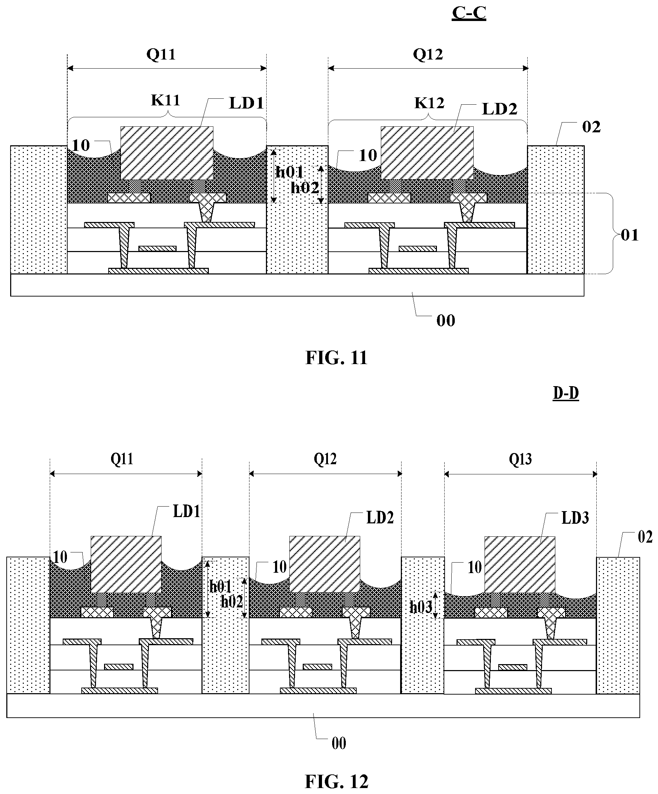

In one embodiment, referring to FIG. 10, only a part of the sidewalls of the light-emitting elements LD in the first region Q11 may be covered by the light-blocking layer 10, and the sidewalls of the light-emitting elements LD in the second region Q12 may be not covered by the light-blocking layer 10, which may be taken as an example for illustration and may not be limited in the present disclosure. In some other embodiments of the present disclosure, when the thickness h01 of the light-blocking layer 10 in the first region Q11 is greater than the thickness h02 of the light-blocking layer 10 in the second region Q12, it may also be embodied as that at least a part of the sidewalls of the light-emitting elements LD in the first region Q11 and at least a part of the sidewalls of the light-emitting elements LD in the second region Q12 may be all covered by the light-blocking layer 10. Referring to FIG. 11, FIG. 11 illustrates another cross-sectional view along the CC direction in FIG. 9. Referring to FIGS. 9-11, in an embodiment of the present disclosure, the display panel may include the plurality of first regions Q11 and the plurality of second regions Q12. When the thickness h01 of the light-blocking layer 10 in the first region Q11 is greater than the thickness h02 of the light-blocking layer 10 in the second region Q12, and when the light-emitting elements LD are disposed in both the first region Q11 and the second region Q12, for the plurality of light-emitting elements LD, at least a part of the sidewalls of the light-emitting elements LD may be in contact with the light-blocking layer 10. In the present disclosure, the thickness h01 of the light-blocking layer 10 in the first region Q11 may be greater than the thickness h02 of the light-blocking layer 10 in the second region Q12, which may indicate that the top surface of the light-blocking layer 10 in the first region Q11 may be higher than the top surface of the light-blocking layer 10 in the second region Q12. At this point, at least the light-blocking layer 10 in the first region Q11 may cover the sidewalls of the light-emitting element LD in the first region Q11. That is, the light-blocking layer 10 may be in contact with the sidewalls of the light-emitting element LD, such that the thickness of the light-blocking layer 10 in the first region Q11 may be relatively large. For the second region Q12, the light-blocking layer 10 may not cover the sidewalls of the light-emitting element LD. That is, the light-blocking layer 10 may be not in contact with the sidewalls of the light-emitting element LD. At this point, the thickness of the light-blocking layer 10 in the second region Q12 may be less than the thickness of the light-blocking layer 10 in the first region Q11, which may reduce the brightness of the light-emitting element LD in the first region Q11 and balance the brightness difference of the light-emitting elements LD with different light-emitting efficiencies in the first region Q11 and the second region Q12. In addition, in some other embodiments, for the second region Q12, its light-blocking layer 10 may also cover the sidewalls of the light-emitting element LD. That is, the light-blocking layer 10 may be in contact with the sidewalls of the light-emitting element LD. At this point, as long as the thickness of the light-blocking layer 10 in contact with the sidewalls of the light-emitting element LD in the second region Q12 is less than the thickness of the light-blocking layer 10 in contact with the sidewalls of the light-emitting element LD in the first region Q11, the brightness of the light-emitting elements LD in the first region Q11 and the second region Q12 may be balanced, thereby improving the display brightness uniformity of the first region Q11 and the second region Q12 in the display panel.

Referring to FIGS. 9-11, in an embodiment of the present disclosure, the light-emitting element LD may include the first light-emitting element LD1 in the first region Q11 and the second light-emitting element LD2 in the second region Q12. The light-emitting efficiency of the first light-emitting element LD1 may be greater than that of the second light-emitting element LD2. The thickness h01 of the light-blocking layer 10 in contact with the sidewalls of the first light-emitting element LD1 may be greater than the thickness h02 of the light-blocking layer 10 in contact with the sidewalls of the second light-emitting element LD2.

For example, in one embodiment, the first light-emitting element LD1 and the second light-emitting element LD2 may emit different colors. The light-emitting efficiency of the first light-emitting element LD1 may be greater than the light-emitting efficiency of the second light-emitting element LD2. In actual applications, if the proportion of the light output of the light-emitting elements LD with high light-emitting efficiency is relatively large, the display panel may have abnormal color display under the white screen. For example, the blue light-emitting element LD may have high light-emitting efficiency. If the proportion of the light output of the blue light-emitting element LD is relatively large, the display panel may have abnormal blue display problem under the white screen. Therefore, in one embodiment, the thickness of the light-blocking layer 10 of the first region Q11 and the thickness of the light-blocking layer 10 of the second region Q12 may be designed differently, such that the light-blocking layer 10 in the first region Q11 may be in contact with the sidewalls of the first light-emitting element LD1 in the first region Q11, and the thickness of the light-blocking layer 10 in contact with the sidewalls of the first light-emitting element LD1 may be greater than the thickness of the light-blocking layer 10 in contact with the sidewalls of the second light-emitting element LD2, which may be beneficial for reducing the lateral light output of the first light-emitting element LD1 with higher light-emitting efficiency, reducing overall brightness of the first light-emitting element LD1, balancing the difference in light-emitting brightness between the first light-emitting element LD1 with higher light-emitting efficiency and the second light-emitting element LD2 with lower light-emitting efficiency, thereby being beneficial for improving the uniformity of overall light-emitting brightness of the display panel and reducing the phenomenon of abnormal color display under the white screen of the display panel.

In an embodiment of the present disclosure, the first light-emitting element LD1 may be a blue light-emitting element LD, and the second light-emitting element LD2 may be a red light-emitting element LD or a green light-emitting element LD. In another embodiment of the present disclosure, the first light-emitting element LD1 may be a green light-emitting element LD, and the second light-emitting element LD2 may be a red light-emitting element LD.

In above-mentioned embodiment, it only describes the solution that the display panel may include the first light-emitting element LD1 and the second light-emitting element LD2. In some other embodiments of the present disclosure, the display panel may also include the third light-emitting element LD3. Referring to FIG. 12, FIG. 12 illustrates a cross-sectional view along a DD direction in FIG. 9. Referring to FIGS. 9 and 12, in one embodiment, the display panel may include the first region Q11, the second region Q12 and the third region Q13. The first region Q11, the second region Q12 and the third region Q13 may be all disposed with the light-emitting elements LD, which may be respectively the first light-emitting element LD1, the second light-emitting element LD2 and the third light-emitting element LD3. Three regions may be pixel regions 31 or redundant pixel regions 32 disposed with the light-emitting elements LD. In three light-emitting elements LD, the first light-emitting element LD1 may have the largest light-emitting efficiency, the second light-emitting element LD2 may have medium light-emitting efficiency, and the third light-emitting element LD3 may have the smallest light-emitting efficiency. The thickness of the light-blocking layer 10 in the first region Q11 may be greater than the thickness of the light-blocking layer 10 in the second region Q12, and the thickness of the light-blocking layer 10 in the second region Q12 may be greater than the thickness of the light-blocking layer 10 in the third region Q13. The light-blocking layer 10 in the first region Q11 may be in contact with the sidewalls of the first light-emitting element LD1, the light-blocking layer 10 in the second region Q12 may be in contact with the sidewalls of the second light-emitting element LD2, and the light-blocking layer 10 in the third region Q13 may be not contact with the sidewalls of the third light-emitting element LD3. In such way, the light-blocking layer 10 may block the most of the lateral light output of the first light-emitting element LD1 and block relatively small amount of the lateral light output of the second light-emitting element LD2, and may not block the lateral light output of the third light-emitting element LD3, thereby being beneficial for reducing the lateral light output (amount) of the first light-emitting element LD1 and the second light-emitting element LD2. Furthermore, the reduction in lateral light output of the first light-emitting element LD1 may be greater than the reduction in lateral light output of the second light-emitting element LD2 which may be beneficial for ensuring the lateral light output of the third light-emitting element LD3, thereby being beneficial for balancing the difference in light-emitting brightness of three light-emitting elements LD with different light-emitting efficiencies and improving the uniformity of overall display brightness of the display panel, and further being beneficial for avoiding or reducing the problem of abnormal color display of the display panel under the white screen.

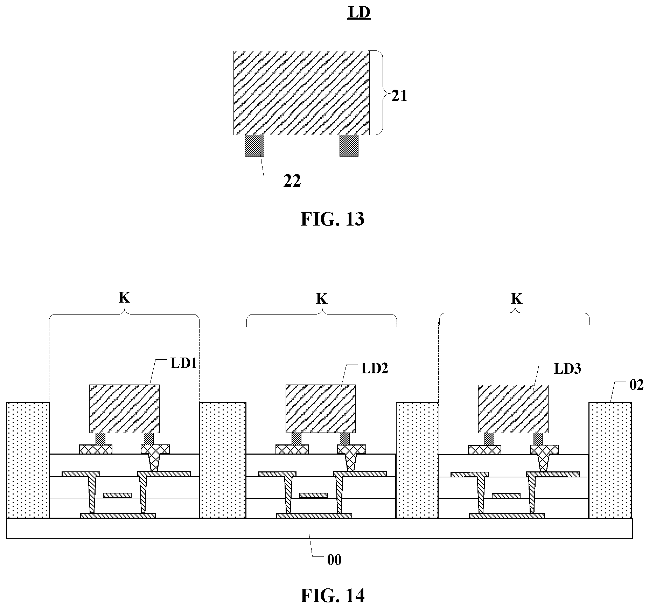

FIG. 13 illustrates a structural schematic of the light-emitting element LD according to various embodiments of the present disclosure. Referring to FIGS. 10, 12 and 13, in an embodiment of the present disclosure, the first region Q11 may be disposed with the light-emitting element LD. The light-emitting element LD may include the light-emitting chip 21 and the electrode 22 on one side of the light-emitting chip 21. The surface of the light-emitting chip 21 away from the electrode 22 may be a plane. The electrode 22 may be on the side of the light-emitting chip 21 facing toward the driving layer 01 and configured to form electrical connection with the driving layer 01.

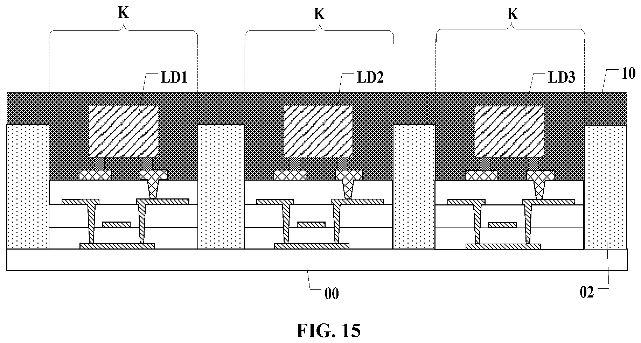

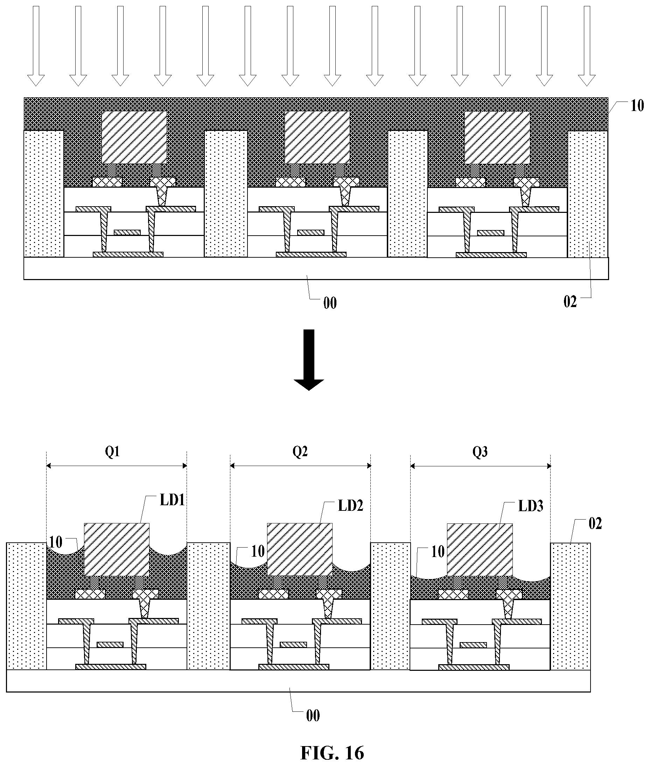

During the formation process of the display panel, after the light-emitting elements LD are bound to the side of the driving layer, the film layers in the regions of the display panel, where the structures including the driving circuits, the light-emitting elements LD and wires are not disposed, may be removed (for example, only the substrate 00 may be retained). The light-transmitting layer 02 may be formed in corresponding region. For example, referring to FIG. 14, FIG. 14 illustrates a formation process schematic of the display panel according to various embodiments of the present disclosure. In such process, the opening K may be formed in the light-transmitting layer 02. The structures including the drive circuit, the light-emitting element, the wire and the like may be in the opening. Subsequently, the light-blocking layer 10 may be formed. For example, referring to FIG. 15, FIG. 15 illustrates another formation process schematic of the display panel according to various embodiments of the present disclosure. In the process of forming the light-blocking layer 10, the light-blocking layer 10 may completely cover the surface of the light-emitting chip 21 away from the electrode 22, the opening formed in the light-transmitting layer 02, and the surface of the light-transmitting layer 02 away from the substrate 00. Furthermore, referring to FIG. 16, photolithography and other processes may be used to remove unnecessary light-blocking layer 10. For example, the light-blocking layer 10 on the surface of the light-transmitting layer 02 and the surface of the light-emitting chip 21 may be at least removed to form similar structure shown in FIG. 16. FIG. 16 illustrates another formation process schematic of the display panel according to various embodiments of the present disclosure. When the surface of the light-emitting chip 21 away from the electrode 22 is a non-planar structure, for example, when there is a concave microstructure on the surface of the light-emitting chip 21 and the light-blocking layer 10 is filled in the concave microstructure, such part of the light-blocking layer 10 may not be easily removed through the photolithography process, which may affect the forward light output of the light-emitting element LD. Therefore, in one embodiment, when the surface of the light-emitting chip 21 in the light-emitting element LD away from the electrode 22 is configured as a planar structure and when the light-blocking layer 10 on the surface of the light-emitting chip 21 needs to be removed, the removal process may be simple, and the light-blocking layer 10 may be easily removed, which may be beneficial for avoiding the residual of the light-blocking layer 10 on the surface of the light-emitting chip 21 and ensuring the forward light output of the light-emitting chip 21.

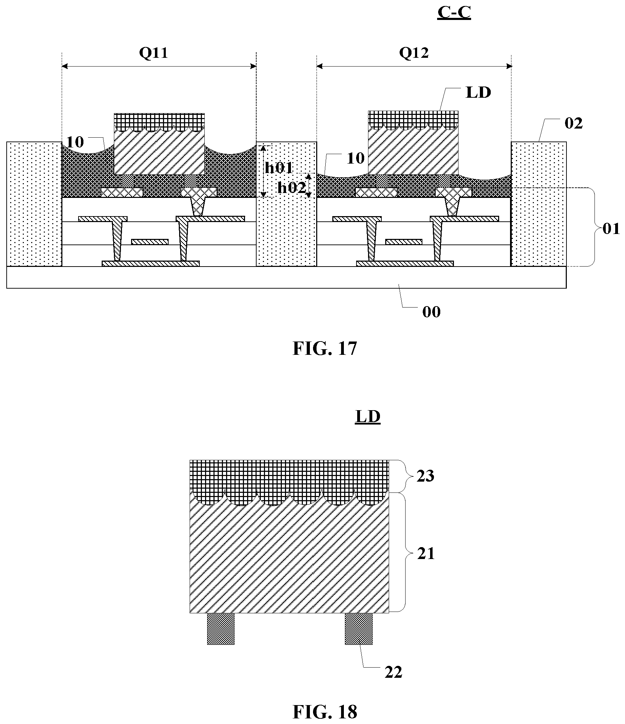

FIG. 17 illustrates another cross-sectional view along the CC direction in FIG. 9. FIG. 18 illustrates a structural schematic of the light-emitting element LD according to various embodiments of the present disclosure. Referring to FIGS. 17-18, in an embodiment of the present disclosure, the light-emitting element LD may be disposed in the first region Q11. The light-emitting element LD may include the light-emitting chip 21 and the electrode 22 located on one side of the light-emitting chip 21. The surface of the light-emitting chip 21 away from the electrode 22 may include a patterned microstructure. The light-emitting element LD may also include a color filter layer 23. The color filter layer 23 may cover the patterned microstructure. The surface of the color filter layer 23 away from the light-emitting chip 21 may be a plane.

Before the light-emitting element LD is transferred to the array layer, the light-emitting element LD may be a finished (formed) structure. During the formation process of the light-emitting element LD, when the patterned microstructure is disposed on the surface of the light-emitting chip 21 away from the electrode 22, the light emitted by the light-emitting chip 21 may be refracted by the patterned microstructure, and more light may be emitted toward the front viewing angle of the light-emitting element LD, which may be beneficial for increasing the light output at the front viewing angle of the light-emitting element LD. When the patterned microstructure is disposed on the surface of the light-emitting chip 21 away from the electrode 22, the color filter layer 23 may be further disposed on the side of the patterned microstructure away from the electrode 22. The color of the color filter layer 23 may be same as the light-emitting color of the light-emitting chip 21, and the surface of the color filter layer 23 away from the light-emitting chip 21 may be a plane. At this point, the color filter layer 23, the light-emitting chip 21 and the electrode 22 may form entire light-emitting element LD. If the light-emitting element LD which such structure is applied to the display panel of the present disclosure, when the light-blocking layer 10 is formed and unnecessary light-blocking layer 10 is removed, the light-blocking layer 10 originally located on the flat surface of the color filter layer 23 may be more easily removed, thereby being beneficial for avoiding the light-blocking layer 10 remaining on the light-emitting surface of the light-emitting element LD, improving the light output of the light-emitting element LD at the front viewing angle, and improving the brightness at the front viewing angle of the light-emitting element LD.

In an embodiment, the light-emitting elements LD in the display panel of the present disclosure may all be embodied as the structure shown in FIG. 18 to improve the brightness of each light-emitting element LD at the front viewing angle. Obviously, in some other embodiments, the light-emitting elements LD in the display panel of the present disclosure may also be embodied as the structure shown in FIG. 13 to take into account the brightness of the display panel at the wide viewing angle; or certain light-emitting elements LD may use the structure shown in FIG. 18, and other light-emitting elements LD may use the structure shown in FIG. 13, which may not be limited in the present disclosure.

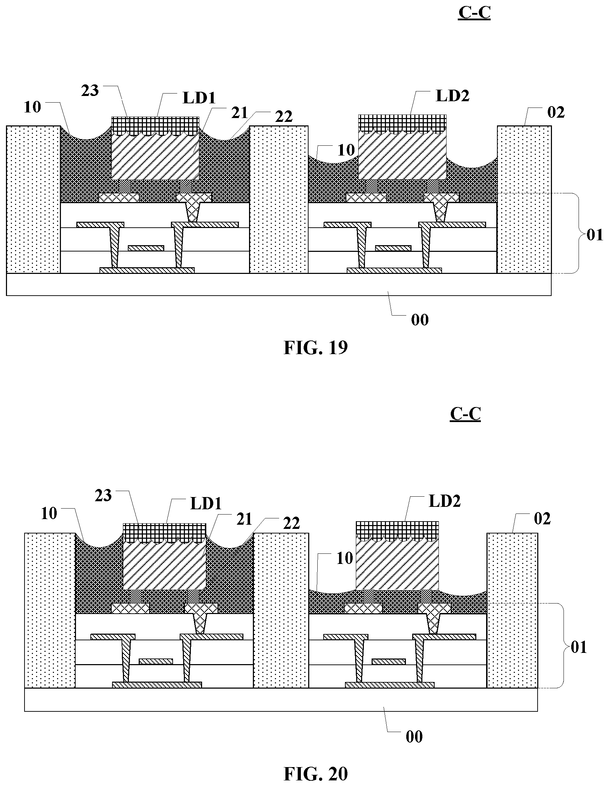

FIG. 19 illustrates another cross-sectional view along a CC direction in FIG. 9. Referring to FIG. 19, in an embodiment of the present disclosure, the light-emitting elements LD may include the first light-emitting element LD1 and the second light-emitting element LD2. The light-emitting efficiency of the first light-emitting element LD1 may be greater than the light-emitting efficiency of the second light-emitting element LD2. In the first region Q1, the light-blocking layer 10 may cover at least a part of the sidewalls of the light-emitting chip 21 and the sidewalls of the color filter layer 23 in the first light-emitting element LD 1, and the light-blocking layer 10 may not cover the sidewalls of the color filter layer 23 in the second light-emitting element LD2.

In one embodiment, the first light-emitting element LD1 and the second light-emitting element LD2 may be both embodied as the structure shown in FIG. 18 for illustration. The surfaces of the light-emitting chip 21 in the first light-emitting element LD1 and the second light-emitting element LD2 facing away from the electrode 22 may include the patterned microstructure. The color filter layer 23 may be located on the surface of the patterned microstructure facing away from the electrode 22. The top surface of the color filter layer 23 may be a flat surface. The light-emitting efficiency of the first light-emitting element LD1 may be greater than the light-emitting efficiency of the second light-emitting element LD2. In order to balance the difference in the light-emitting brightnesses between the first light-emitting element LD1 and the second light-emitting element LD2, the light-blocking layer 10 in one embodiment may cover the sidewalls of the light-emitting chip 21 and the sidewalls of the color filter layer 23 in the first light-emitting element LD1, which may be equivalent to blocking the lateral light emission of the light-emitting element LD and reducing overall brightness of the first light-emitting element LD1. For the second light-emitting element LD2 with low light-emitting efficiency, the light-blocking layer 10 may not cover the sidewalls of the color filter layer 23 of the second light-emitting element LD2. In one embodiment, the light-blocking layer 10 covering only a part of the sidewalls of the light-emitting chip 21 in the second light-emitting element LD2 is taken as an example for illustration. In such way, the second light-emitting element LD2 may still retain the lateral light emission to increase overall light emission of the second light-emitting element LD2, improve the brightness of the second light-emitting element LD2 and balance the difference in the light-emitting brightnesses between the second light-emitting element LD2 and the third light-emitting element LD3, thereby being beneficial for improving overall display brightness uniformity of the display panel.

In some other embodiments of the present disclosure, for the second light-emitting element LD2 with low light-emitting efficiency, the light-blocking layer 10 may also be configured to completely expose the sidewalls of the light-emitting chip 21 and the sidewalls of the color film layer 23 in the second light-emitting element LD2 as shown in FIG. 20 exemplarily, which may further increase the lateral light output of the second light-emitting element LD2 to improve overall brightness of the second light-emitting element LD2, reduce the difference in the light-emitting brightnesses between the second light-emitting element LD2 and the first light-emitting element LD1, and improve the uniformity of overall display brightness. FIG. 20 illustrates another cross-sectional view along the CC direction in FIG. 9.

It should be noted that the light-emitting element LD may include the light-emitting chip 21 and the electrode 22. The (light-emitting) electrode 22 may be a metal electrode 22. When the light-blocking layer 10 is formed in the opening corresponding to the light-emitting element LD, the light-blocking layer 10 may completely cover the electrode 22 of the light-emitting element LD, thereby preventing the metal electrode 22 from reflecting light and affecting the display effect of the display panel.

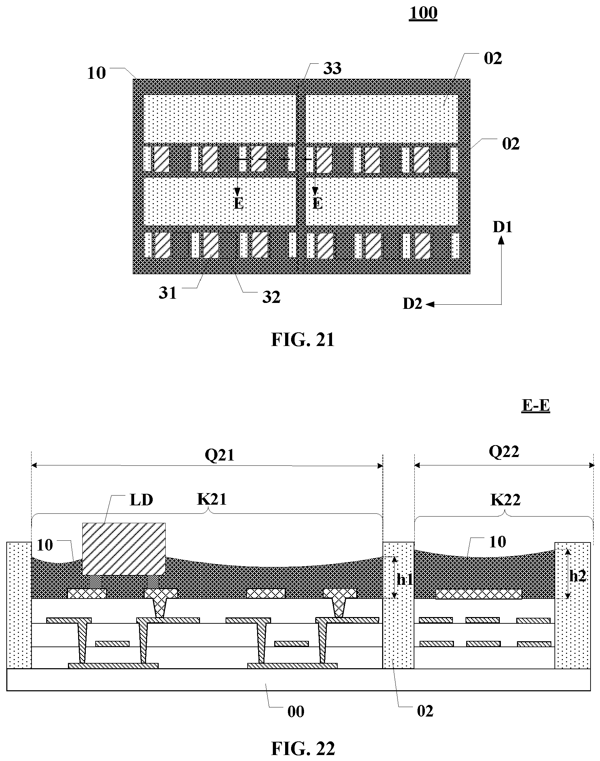

The top views shown in FIGS. 1 and 3 illustrate the solution that the pixel region 31 and the redundant pixel region 32 may be distributed on two sides of the light-transmitting layer 02 along the first direction D1. The row of the pixel region 31 and the row of the redundant pixel region 32 may be arranged along the first direction D1, which may not be limited in the present disclosure. For example, referring to FIG. 21, FIG. 21 illustrates another partial top view of the display panel according to various embodiments of the present disclosure. In one embodiment, the pixel region 31 and the redundant pixel region 32 may be arranged along the second direction D2. The pixel region 31 and corresponding redundant pixel region 32 may be arranged adjacent to each other along the second direction D2. At this point, the distribution of the first region Q1 and the second region Q2 in embodiments of the present disclosure may also be embodied as the distribution shown in FIG. 22. FIG. 22 illustrates a cross-sectional view along an EE direction in FIG. 21. Referring to FIGS. 21-22, in an embodiment of the present disclosure, the first region Q21 may be disposed with the light-emitting element LD, the first region Q21 may include the pixel region 31 and the redundant pixel region 32, and the second region Q22 may be the wiring region 33. The first opening K21 may be in the first region Q21, and the second opening K22 may be in the second region Q22. When the redundant pixel region 32 is configured on the side of the pixel region 31 along the second direction D2, that is, the pixel region 31 and the redundant pixel region 32 are configured to be adjacent to each other, the distance between the pixel region 31 and the redundant pixel region 32 may be closer, which may be more beneficial for achieving indiscriminate repair of the light-emitting elements in the pixel region 31 which do not emit light. In embodiments of the present disclosure, the first region Q1 may include both the pixel region 31 and the redundant pixel region 32. The second region Q2 may be the wiring region 33. At this point, the thicknesses of the light-blocking layer 10 in the first region Q1 and the second region Q2 may be different.

In an embodiment, the thickness h1 of the light-blocking layer 10 in the first region Q1 may be less than the thickness h2 of the light-blocking layer 10 in the second region Q2, which may also balance the light-blocking effect of the light-blocking layer 10 in the first region Q1 and the second region Q2 and improve overall contrast consistency of the display panel, thereby improving the viewing effect of the user.

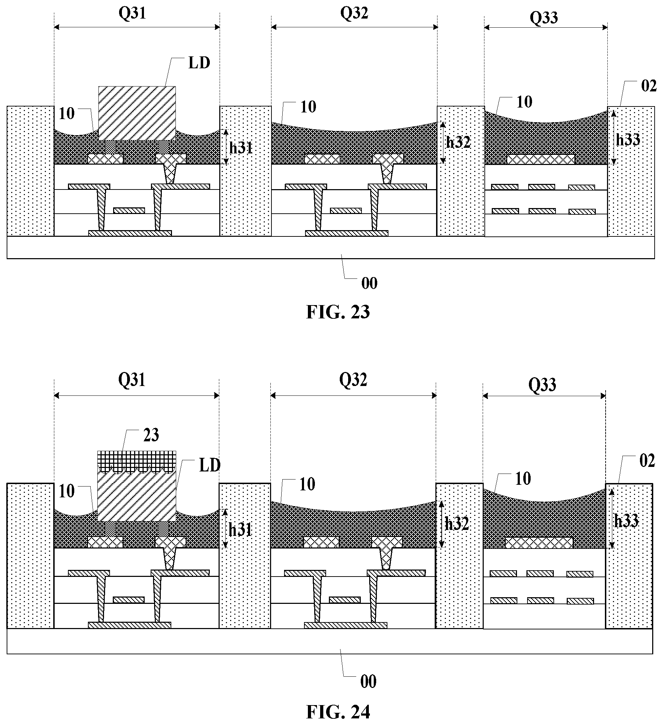

FIGS. 23-24 illustrate film layer schematics of the relationship between light-blocking layers in the first region, the second region, and the third region according to various embodiments of the present disclosure. Referring to FIGS. 23 and 24, in the display panel provided in one embodiment, the first region Q31, the second region Q32, and the third region Q33 may be isolated by the light-transmitting layer 02. The first region Q31 may be disposed with the light-emitting element LD. The second region Q32 may be the redundant pixel region not disposed with the light-emitting element. The third region Q33 may be the wiring region. The first region Q31, the second region Q32 and the third region Q33 may be all disposed with the light-blocking layer 10. The cross section in FIGS. 23 and 24 may be perpendicular to the plane where the light-emitting surface of the display panel is located. In such cross section, in an embodiment, the width of the first region Q31 may be equal to the width of the second region Q32, and the width of the second region Q32 may be greater than the width of the third region Q33. The thickness h31 of the light-blocking layer 10 disposed in the first region Q31 may be less than the thickness h32 of the light-blocking layer 10 disposed in the second region Q32, and the thickness h32 of the light-blocking layer 10 disposed in the second region Q32 may be less than the thickness h33 of the light-blocking layer 10 disposed in the third region Q33. That is, the thickness of the light-blocking layer 10 in the first region Q31, the second region Q32 and the third region Q33 may increase. Such configuration may be also beneficial for balancing the difference in the light-blocking effect of the light-blocking layer in different regions, improving the contrast consistency of different regions, and further improving overall display effect of the display panel and the viewing experience of the user.

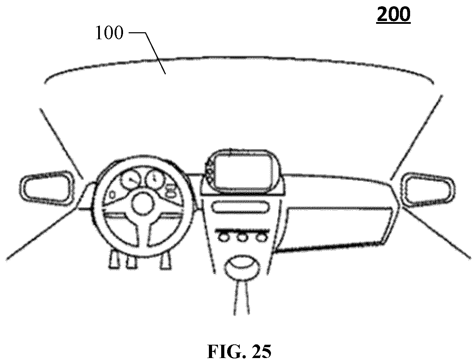

Based on same inventive concept, the present disclosure further provides a display apparatus. FIG. 25 illustrates a structural schematic of the display apparatus according to various embodiments of the present disclosure. Referring to FIG. 25, the display apparatus 200 may include the display panel 100 in any of above-mentioned embodiments. The display apparatus 200 provided in embodiments of the present disclosure may be any electronic device with display function, such as a tablet computer with touch and display functions, a display cabinet display product, a television or a vehicle-mounted display apparatus and/or the like; and may be particularly suitable for the display apparatus with transparent display function. The display apparatus 200 provided in embodiments of the present disclosure has the beneficial effects of the display panel 100 provided in embodiments of the present disclosure, which may refer to specific description of the display panel 100 in above-mentioned embodiments and may not be described in detail in embodiments of the present disclosure.

It should be understood that FIG. 25 only illustrates one shape of the display apparatus 200 by taking the vehicle-mounted display apparatus as an example. In some other embodiments of the present disclosure, the display apparatus 200 may also be embodied as a circle, an ellipse or any other feasible shape, and may be applied to other types of display apparatuses, which may not be limited in the present disclosure. For the vehicle-mounted display apparatus, the contrast may directly affect the driving experience of the driver. The display panel provided in above-mentioned embodiments of the present disclosure may improve the consistency of the light-blocking effect and the contrast of the display panel in different regions, thereby improving the viewing experience of the user and ensuring the driving safety of the driver.

It may be seen from above-mentioned embodiments that the present disclosure may at least achieve following beneficial effects.

In the display panel and the display apparatus provided in embodiments of the present disclosure, the first region and the second region may be provided. The structures in the first region and the second region may have differences, such as whether the light-emitting elements are configured, whether the pixel driving circuits are configured, the color difference of the light-emitting elements or the like. Based on structural differences in the first region and the second region, in the present disclosure, the thickness of the light-blocking layer in the first region may be configured to be different from the thickness of the light-blocking layer in the second region, which may be beneficial for reducing the reflectivity of the first region and the second region, balancing the difference in anti-reflection effect in the first region and the second region and improving the consistency of overall anti-reflection effect, and further beneficial for improving the consistency of overall contrast of the display product and the display effect.

It should be noted that in the present disclosure, relational terms such as "first" and "second" may be only configured to distinguish one entity or operation from another entity or operation and may not necessarily require or imply that such actual relationship or order is between these entities or operations. Furthermore, the term "comprise", "include" or any other variation thereof may be intended to cover a non-exclusive inclusion. Therefore, a process, a method, an article or apparatus including a set of elements may include not only those elements, but also other elements not expressly listed, or also include elements inherent in the process, the method, the article or apparatus. Without further limitations, an element defined by the statement "include ..." may not exclude the presence of additional identical elements in the process, the method, the article, or apparatus including such element.

The above may be merely embodiments of the present disclosure, which may make those skilled in the art to understand or implement the present disclosure. Various modifications to embodiments of the present disclosure may be apparent to those skilled in the art. General principles defined in the present disclosure may be implemented in other embodiments without departing from the scope of the present disclosure. Therefore, the present disclosure may not be limited to embodiments described in the present disclosure but may be accorded the widest scope consistent with the principles and novel features of the present disclosure.

## Claims

1. A display panel, **characterized by** comprising:
a light-blocking layer, wherein a thickness of the light-blocking layer in a first region included in the display panel is different from a thickness of the light-blocking layer in a second region included in the display panel.

2. The display panel according to claim 1, further comprising:
a light-transmitting layer, wherein the light-transmitting layer comprises openings, the openings comprise a first opening and a second opening, the light-blocking layer is disposed in the first opening and the second opening, and a thickness of the light-blocking layer in the first opening is different form a thickness of the light-blocking layer in the second opening.

3. The display panel according to claim 2, wherein a top surface of at least a part of the light-blocking layer does not exceed a top of a corresponding opening.

4. The display panel according to claim 1, wherein in a plurality of first regions, a thickness of the light-blocking layer in at least a part of the plurality of first regions is less than a thickness of the light-blocking layer in a corresponding second region.

5. The display panel according to claims 1 or 4, wherein the first region is disposed with a light-emitting element, and the second region is a redundant pixel region without the light-emitting element or a wiring region.

6. The display panel according to claim 5, further comprising:
a light-transmitting layer, wherein the light-transmitting layer comprises openings, the openings comprise a first opening and a second opening, the first opening is in the first region, the second opening is in the second region, and an area of a projection of the first opening on a plane of a substrate is same as an area of a projection of the second opening on the plane of the substrate.

7. The display panel according to claim 6, wherein a thickness difference Δh between the light-blocking layer in the second region and the light-blocking layer in the first region is calculated as:

$$\Delta h = (H*C*\omega)/C - (H*C-V)*\omega)/(C-S),$$

wherein V denotes a volume of a light-emitting chip in the light-emitting element, S denotes a volume of an electrode in the light-emitting element, H denotes a thickness of the light-transmitting layer, C denotes a volume of an opening, and ω denotes a solid content of the light-blocking layer.

8. The display panel according to claim 6, wherein a thickness difference Δh between the light-blocking layer in the second region and the light-blocking layer in the first region is calculated as:

$$\Delta h = V*\omega/C,$$

wherein V denotes a volume of a light-emitting chip in the light-emitting element, $\omega$ denotes a solid content of the light-blocking layer, and C denotes a volume of an opening.

**9.** The display panel according to claim 5, wherein in the first region, the light-blocking layer exposes at least a part of the sidewall of the light-emitting element.

**10.** The display panel according to claim 9, wherein in a plurality of light-emitting elements, sidewalls of a part of the plurality of light-emitting elements are not covered by the light-blocking layer.

**11.** The display panel according to claim 9, wherein in a plurality of light-emitting elements, sidewalls of a part of the plurality of light-emitting elements are covered by the light-blocking layer.

**12.** The display panel according to claim 5, wherein a plane where a top surface of the light-blocking layer in the redundant pixel region is located is lower than a plane where a top surface of the light-emitting element in the first region is located.

**13.** The display panel according to claim **1,** further comprising:
a third region, wherein the thickness of the light-blocking layer in the first region is less than the thickness of the light-blocking layer in the second region, the thickness of the light-blocking layer in the first region is less than a thickness of the light-blocking layer in the third region, and the thickness of the light-blocking layer at the third region is less than or equal to the thickness of the light-blocking layer in the second region.

**14.** The display panel according to claim 13, wherein the first region is disposed with the light-emitting element, the second region is a redundant pixel area without light-emitting element, and the third region is a wiring region.

**15.** The display panel according to claim **1,** wherein in a plurality of first regions, a thickness of the light-blocking layer in at least a part of plurality of first regions is greater than a thickness of the light-blocking layer in a corresponding second region.

**16.** The display panel according to claim 15, wherein the first region and the second region are both disposed with light-emitting elements.

**17.** The display panel according to claim 16, wherein in a plurality of light-emitting elements, sidewalls of at least a part of the plurality of light-emitting elements are in contact with the light-blocking layer.

**18.** The display panel according to claim 17, wherein the plurality of light-emitting elements comprises a first light-emitting element in the first region and a second light-emitting element in the second region, a light-emitting efficiency of the first light-emitting element is greater than a light-emitting efficiency of the second light-emitting element, and a thickness of the light-blocking layer in contact with a sidewall of the first light-emitting element is greater than a thickness of the light-blocking layer in contact with a sidewall of the second light emitting element.

**19.** The display panel according to claim 2, wherein a top surface morphology of the light-blocking layer in the first opening is different from a top surface morphology of the light-blocking layer in the second opening.

**20.** The display panel according to claims 2 or 19, wherein a part of a top surface of the light-blocking layer comprises a curved surface.

**21.** The display panel according to claim 20, wherein

a light-emitting element is disposed in the first opening;
in the first opening, a part of a top surface of the light-blocking layer forms a first curved surface;
in the second opening, a top surface of the light-blocking layer forms a second curved surface; and
a curvature of the first curved surface is different from a curvature of the second curved surface.

**22.** The display panel according to claim 21, wherein an orthographic projection of lowest points of the first curved surface on a light-emitting surface of the display panel is at least on two sides of the light-emitting element, and an orthographic projection of lowest points of the second curved surface on the light-emitting surface of the display panel is a line.

**23.** The display panel according to claim 21, wherein the curvature of the first curved surface is less than the curvature of the second curved surface.

**24.** The display panel according to claim 1, wherein

a light-emitting element is disposed in the first region; and
the light-emitting element comprises a light-emitting chip and an electrode on a side of the light-emitting chip, and a surface of the light-emitting chip being away from the electrode is a plane.

**25.** The display panel according to claim **1,** wherein

a light-emitting element is disposed in the first region;
the light-emitting element comprises a light-emitting chip and an electrode on a side of the light-emitting chip, and a surface of the light-emitting chip being away from the electrode comprises a patterned microstructure; and
the light-emitting element further comprises a color filter layer, the color filter layer covers the patterned microstructure, and a surface of the color filter layer being away from the light-emitting chip is a plane.

**26.** The display panel according to claim 25, wherein

the light-emitting element comprises a first light-emitting element and a second light-emitting element;
a light-emitting efficiency of the first light-emitting element is greater than a light-emitting efficiency of the second light-emitting element; and
in the first region, the light-blocking layer covers at least a part of a sidewall of the light-emitting chip and a part of a sidewall of the color filter layer in the first light-emitting element, and the light-blocking layer does not cover a sidewall of the color filter layer in the second light-emitting element.

**27.** The display panel according to claims 1 or 4, wherein the first region is disposed with a light-emitting element, the first region comprises a pixel region and a redundant pixel region, and the second region is a wiring region.

**28.** A display apparatus, **characterized by** comprising the display panel according to any one of claims 1 to 27.

**FIG. 1**

**FIG. 2**

**FIG. 3**

A-A

Q1

K/K1    LD    21

22

Q2

K/K2

10

02

10

10

01

00

**FIG. 4**

A-A

Q1

K/K1    LD

10

Q2

K/K2

10

02

01

00

**FIG. 5**

FIG. 6

FIG. 7

**FIG. 8**

**FIG. 9**

**FIG. 10**

C-C

**FIG. 11**

D-D

**FIG. 12**

LD

21

22

**FIG. 13**

K          K          K

LD1        LD2        LD3        02

00

**FIG. 14**

K                    K                    K

LD1                  LD2                  LD3            10

00                                              02

**FIG. 15**

10

00

02

Q1

LD1

10

Q2

LD2

10

Q3

LD3

02

10

00

**FIG. 16**

C-C

Q11  Q12

LD

02

10

h01
h02

10

01

00

**FIG. 17**

LD

23

21

22

**FIG. 18**

C-C

**FIG. 19**

C-C

**FIG. 20**

**100**

10  33  02

02

D1

E  E

D2

31  32

**FIG. 21**

E-E

Q21  Q22

LD  K21  K22

10  10

h1  h2

00  02

**FIG. 22**

Q31    Q32    Q33

LD

10    10    02

h31    h32    h33

00

**FIG. 23**

Q31    Q32    Q33

23

LD

10    10    02

h31    h32    h33

00

**FIG. 24**

**FIG. 25**

Europäisches
Patentamt

European
Patent Office

Office européen
des brevets

## EUROPEAN SEARCH REPORT

**Application Number**

EP 25 20 3272

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (IPC) |
| X | US 2022/149246 A1 (PARK JAE HYUN [KR] ET AL) 12 May 2022 (2022-05-12)<br><br>* paragraph [0081] - paragraph [0087] *<br>----- | 1,4,5,<br>12,13,<br>15,24,<br>27,28 | INV.<br>H10H29/30<br>H10H29/41<br>H10H29/853<br><br>ADD.<br>H10H29/855<br>H10H29/80 |
| X | US 2024/072103 A1 (LEE JI HYE [KR] ET AL) 29 February 2024 (2024-02-29)<br><br>* paragraphs [0151], [0233], [0249], [0252]; figures 3,11 *<br>----- | 1-15,<br>19-23,<br>25-28 | |
| A | | 16-18 | |
| X | US 2022/005791 A1 (YU QUANPENG [CN] ET AL) 6 January 2022 (2022-01-06)<br><br>* paragraphs [0038] - [0053]; figures 1-5 *<br>----- | 1-4,13,<br>15,20,<br>24,27,28 | |

**TECHNICAL FIELDS SEARCHED (IPC)**

H10H

The present search report has been drawn up for all claims

| Place of search | Date of completion of the search | Examiner |
|---|---|---|
| The Hague | 26 January 2026 | Dehestru, Bastien |

EPO FORM 1503 03.82 (P04C01)

## ANNEX TO THE EUROPEAN SEARCH REPORT
## ON EUROPEAN PATENT APPLICATION NO.

EP 25 20 3272

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2026

| Patent document cited in search report | Publication date | Patent family member(s) | Publication date |
|---|---|---|---|
| US 2022149246 A1 | 12-05-2022 | CN 116325169 A | 23-06-2023 |
| | | CN 216120335 U | 22-03-2022 |
| | | EP 4246583 A1 | 20-09-2023 |
| | | JP 2023548679 A | 20-11-2023 |
| | | KR 20230117587 A | 08-08-2023 |
| | | US 2022149246 A1 | 12-05-2022 |
| | | US 2025151478 A1 | 08-05-2025 |
| | | WO 2022103200 A1 | 19-05-2022 |
| US 2024072103 A1 | 29-02-2024 | CN 117637795 A | 01-03-2024 |
| | | EP 4328970 A1 | 28-02-2024 |
| | | KR 20240027935 A | 05-03-2024 |
| | | US 2024072103 A1 | 29-02-2024 |
| US 2022005791 A1 | 06-01-2022 | CN 113488498 A | 08-10-2021 |
| | | CN 118299397 A | 05-07-2024 |
| | | US 2022005791 A1 | 06-01-2022 |
| | | US 2024429211 A1 | 26-12-2024 |

EPO FORM P0459

For more details about this annex : see Official Journal of the European Patent Office, No. 12/82